(19) Europäisches Patentamt
European Patent Office
Office européen des brevets

(11) **EP 2 472 627 A1**

(12) **EUROPEAN PATENT APPLICATION**
published in accordance with Art. 153(4) EPC

(43) Date of publication:
**04.07.2012 Bulletin 2012/27**

(21) Application number: **10811683.1**

(22) Date of filing: **09.08.2010**

(51) Int Cl.:
*H01L 51/42* (2006.01)  *H01L 27/146* (2006.01)
*H01M 14/00* (2006.01)

(86) International application number:
**PCT/JP2010/063472**

(87) International publication number:
**WO 2011/024633 (03.03.2011 Gazette 2011/09)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **28.08.2009 JP 2009197975**

(71) Applicant: **Sony Corporation**
**Tokyo 108-0075 (JP)**

(72) Inventors:
• **YAMADA Seiji**
**Tokyo 108-0075 (JP)**

• **LUO Wei**
**Tokyo 108-0075 (JP)**
• **GOTO Yoshio**
**Tokyo 108-0075 (JP)**
• **TOKITA Yuichi**
**Tokyo 108-0075 (JP)**

(74) Representative: **Müller - Hoffmann & Partner Patentanwälte**
**Innere Wiener Strasse 17**
**81667 München (DE)**

(54) **PROTEIN PHOTOELECTRIC CONVERSION ELEMENT, AND TIN-SUBSTITUTED CYTOCHROME C**

(57)    There are provided a novel protein which has extremely high stability with respect to light irradiation, and is capable of maintaining a photoelectric conversion function for a long time, and a protein photoelectric transducer which uses the protein, and is capable of being stably used for a long time. A tin-substituted horse-heart cytochrome c is obtained by substituting tin for iron as a central metal of a heme of a horse-heart cytochrome c. A tin-substituted bovine-heart cytochrome c is obtained by substituting tin for iron as a central metal of a heme of a bovine-heart cytochrome c. A protein 22 made of the tin-substituted horse-heart cytochrome c or the tin-substituted bovine-heart cytochrome c is immobilized on an electrode 21 to form a protein-immobilized electrode. A protein photoelectric transducer is formed with use of the protein-immobilized electrode.

FIG. 9

**Description**

TECHNICAL FIELD

The present invention relates to a protein photoelectric transducer and a tin-substituted cytochrome c, and relates to, for example, a tin-substituted horse-heart cytochrome c, a tin-substituted bovine-heart cytochrome c, and the like, and a protein photoelectric transducer using thereof.

BACKGROUND ART

Proteins exert complicated functions in spite of an extremely small size (2 nm to 10 nm); therefore, the proteins are promising next-generation functional elements as an alternative to semiconductor elements.
In related art, as a photoelectric transducer using a protein, there is proposed a photoelectric transducer using a protein-immobilized electrode formed by immobilizing a zinc-substituted horse-heart cytochrome c (a horse-heart cytochrome c having zinc substituted for iron as a central metal of a prosthetic group heme of a horse-heart cytochrome c) on a gold electrode (refer to PTL 1). Then, it is reported that a photocurrent is obtained by the protein-immobilized electrode.

[Citation list]

[Patent Literature]

    [PTL 1] Japanese Unexamined Patent Application Publication No. 2007-220445
    [PTL 2] Japanese Unexamined Patent Application Publication No. 2009-21501

[Non-patent Literature]

    [NPTL 1] McLendon, G. and Smith, M.J.Biol.Chem. 253, 4004 (1978)
    [NPTL 2] Moza, B.and 2 others, Biochim. Biophys. Acta 1646, 49 (2003)
    [NPTL 3] Vanderkooi, J. M. and 2 others, Eur. J. Biochem. 64, 381-387 (1976)
    [NPTL 4] Tokita, Y. and 4 others, J. Am. Chem. Soc. 130,5302 (2008)
    [NPTL 5] Gouterman M., Optical spectra and electronic structure of porphyrins and related rings, in "The Porphyrins" Vol.3, Dolphin, D. ed., pp. 1-156, Academic Press (1978)

DISCLOSURE OF THE INVENTION

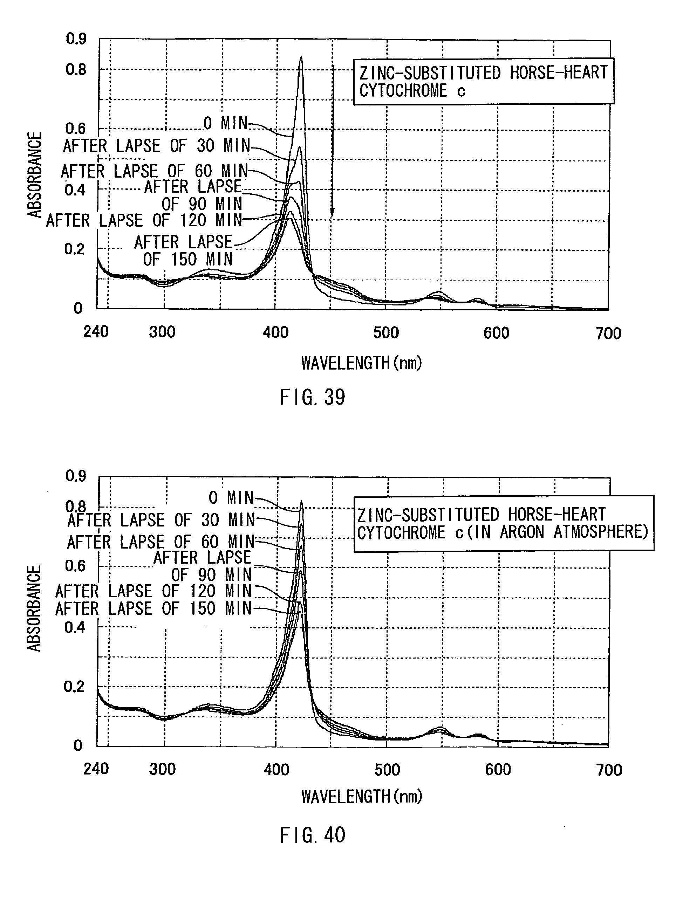

However, it has been found out from studies by the inventors and others of the present invention that a zinc porphyrin which is a prosthetic group in a zinc-substituted horse-heart cytochrome c used in a photoelectric transducer proposed in PTL 1 is unstable with respect to light, and is rapidly decomposed by light irradiation. FIG. 39 illustrates a measurement result of changes with time, caused by light irradiation, in an ultraviolet-visible absorption spectrum of a zinc-substituted horse-heart cytochrome c. In this measurement, 1 mL of a 4 $\mu$M zinc-substituted horse-heart cytochrome c solution (dissolved in a 10 mM sodium phosphate buffer solution (pH 7.0)) was put into a cuvette, and was irradiated with light with a wavelength of 420 nm (an intensity of 1630 $\mu$W) in a dark room at room temperature. An ultraviolet-visible absorption spectrum in a wavelength range of 240 nm to 700 nm was measured every 30 minutes. An arrow in FIG. 39 indicates a spectrum change direction. It is apparent from FIG. 39 that the zinc-substituted horse-heart cytochrome c is rapidly photolyzed with time. A photolysis rate constant k at this time was 114 $M^{-1}s^{-1}$. Although specific description will not be given, a zinc-substituted bovine-heart cytochrome c is also rapidly decomposed by light irradiation.
To prevent photolysis, it is considered to insulate oxygen in an environment where the zinc-substituted horse-heart cytochrome c and the zinc-substituted bovine-heart cytochrome c are present, or to add a radical-trapping agent; however, such measures only allow photolysis to be reduced to approximately 1/3. More specifically, FIG. 40 illustrates a measurement result of changes with time, caused by light irradiation, in an ultraviolet-visible absorption spectrum of a zinc-substituted horse-heart cytochrome c in an argon atmosphere. The measurement method is the same as the above-described method. However, a cuvette containing the zinc-substituted horse-heart cytochrome c solution was sealed with a screw cap, and a deoxidized argon gas was fed into the cuvette for 15 minutes. A photolysis rate constant k at this time was 37.5 $M^{-1}s^{-1}$, which was only approximately 1/3 of that in the case where oxygen was not insulated.

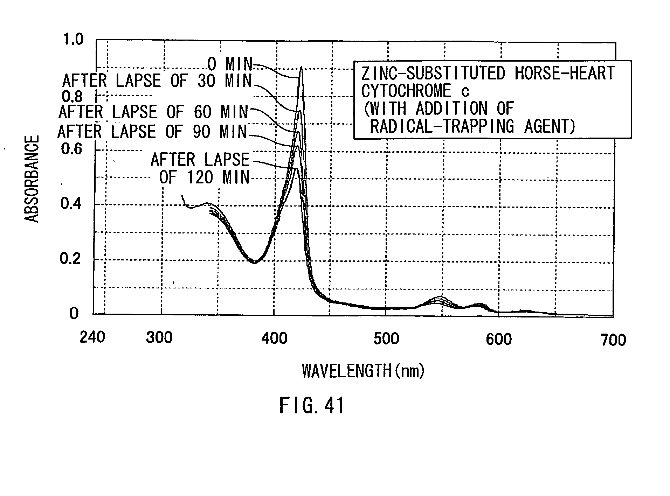

Moreover, FIG. 41 illustrates a measurement result of changes with time, caused by light irradiation, in an ultraviolet-visible absorption spectrum of a zinc-substituted horse-heart cytochrome c with addition of a radical-trapping agent. The measurement method is the same as the above-described method. However, as the radical-trapping agent, 10 mM sodium ascorbate (pH 7.0) was added to the cuvette containing the zinc-substituted horse-heart cytochrome c solution, and the cuvette was not sealed. A photolysis rate constant k at this time was 39.3 $M^{-1}s^{-1}$, which was only approximately 1/3 of that in the case where oxygen was not insulated.

Therefore, an object to be achieved by the present invention is to provide a novel protein which has extremely high stability with respect to light irradiation and is capable of maintaining a photoelectric conversion function for a long time, and a protein photoelectric transducer which uses the protein and is capable of being stably used for a long time.

Through extensive studies to achieve the above-described object, the inventors and the others first succeeded in synthesizing novel proteins which have extremely high stability with respect to light irradiation and are capable of maintaining a photoelectric conversion function for a long time. More specifically, a tin-substituted horse-heart cytochrome c and a tin-substituted bovine-heart cytochrome c formed by substituting tin for iron as central metals of hemes of a horse-heart cytochrome c and bovine-heart cytochrome c, respectively, were synthesized, and stability with respect to light irradiation and long-term maintenance of the photoelectric conversion function of the tin-substituted horse-heart cytochrome c and the tin-substituted bovine-heart cytochrome c were confirmed. Any mammalian cytochrome c other than the horse-heart cytochrome c and the bovine-heart cytochrome c is allowed to obtain similar superior properties. Moreover, a protein having an amino-acid sequence formed by deletion, substitution, or addition of one or more amino acids in the amino-acid sequence of the horse-heart cytochrome c, the bovine-heart cytochrome c, or the mammalian cytochrome c, and including tin is allowed to obtain similar superior properties. Further, even in the case where a metal other than tin and zinc is used as a substitution metal instead of tin, as long as a fluorescence excitation lifetime is within a predetermined time, a metal-substituted cytochrome c or a protein having similar superior properties is allowed to be obtained.

The present invention is achieved based on the above-described studies by the inventors and the others.

More specifically, to achieve the above-described object, the present invention provides a tin-substituted horse-heart cytochrome c formed by substituting tin for iron as a central metal of a heme of a horse-heart cytochrome c.

Moreover, the present invention provides a tin-substituted bovine-heart cytochrome c formed by substituting tin for iron as a central metal of a heme of a bovine-heart cytochrome c.

Further, the present invention provides a protein having an amino-acid sequence formed by deletion, substitution, or addition of one or more amino acids in the amino-acid sequence of a horse-heart cytochrome c, and including tin. Moreover, the present invention provides a protein having an amino-acid sequence formed by deletion, substitution, or addition of one or more amino acids in the amino-acid sequence of a bovine-heart cytochrome c, and including tin.

Further, the present invention provides a tin-substituted cytochrome c formed by substituting tin for iron as a central metal of a heme of a mammalian cytochrome c.

Moreover, the present invention provides a protein having an amino-acid sequence formed by deletion, substitution, or addition of one or more amino acids in the amino-acid sequence of a mammalian cytochrome c, and including tin.

Further, the present invention provides a protein photoelectric transducer including a tin-substituted horse-heart cytochrome c.

Moreover, the present invention provides a protein photoelectric transducer including a tin-substituted bovine-heart cytochrome c.

Further, the present invention provides a protein photoelectric transducer including a protein having an amino-acid sequence formed by deletion, substitution, or addition of one or more amino acids in the amino-acid sequence of a horse-heart cytochrome c, and including tin.

Moreover, the present invention provides a protein photoelectric transducer including a protein having an amino-acid sequence formed by deletion, substitution, or addition of one or more amino acids in the amino-acid sequence of a bovine-heart cytochrome c, and including tin.

Further, the present invention provides a protein photoelectric transducer including a tin-substituted cytochrome c formed by substituting tin for iron as a central metal of a heme of a mammalian cytochrome c.

Moreover, the present invention provides a protein photoelectric transducer including a protein having an amino-acid sequence formed by deletion, substitution, or addition of one or more amino acids in the amino-acid sequence of a mammalian cytochrome c, and including tin.

Further, the present invention provides a metal-substituted horse-heart cytochrome c formed by substituting a metal other than zinc and tin for iron as a central metal of a heme of a horse-heart cytochrome c, and having a fluorescence excitation lifetime $\tau$ of $5.0\times10^{-11}$ s$<\tau\leq8.0\times10^{-10}$ s.

Moreover, the present invention provides a metal-substituted bovine-heart cytochrome c formed by substituting a metal other than zinc and tin for iron as a central metal of a heme of a bovine-heart cytochrome c, and having a fluorescence excitation lifetime $\tau$ of $5.0\times10^{-11}$ s$<\tau\leq8.0\times10^{-10}$ s.

Further, the present invention provides a protein having an amino-acid sequence formed by deletion, substitution, or addition of one or more amino acids in the amino-acid sequence of a horse-heart cytochrome c, including a metal other than zinc and tin, and having a fluorescence excitation lifetime $\tau$ of $5.0 \times 10^{-11}$ s $< \tau \leq 8.0 \times 10^{-10}$ s.

Moreover, the present invention provides a protein having an amino-acid sequence formed by deletion, substitution, or addition of one or more amino acids in the amino-acid sequence of a bovine-heart cytochrome c, including a metal other than zinc and tin, and having a fluorescence excitation lifetime $\tau$ of $5.0 \times 10^{-11}$ s $< \tau \leq 8.0 \times 10^{-10}$ s.

Further, the present invention provides a metal-substituted cytochrome c formed by substituting a metal other than zinc and tin for iron as a central metal of a heme of a mammalian cytochrome c, and having a fluorescence excitation lifetime $\tau$ of $5.0 \times 10^{-11}$ s $< \tau \leq 8.0 \times 10^{-10}$ s.

Moreover, the present invention provides a protein having an amino-acid sequence formed by deletion, substitution, or addition of one or more amino acids in the amino-acid sequence of a mammalian cytochrome c, including a metal other than zinc and tin, and having a fluorescence excitation lifetime $\tau$ of $5.0 \times 10^{-11}$ s $< \tau \leq 8.0 \times 10^{-10}$ s.

Further, the present invention provides a protein photoelectric transducer including a metal-substituted horse-heart cytochrome c formed by substituting a metal other than zinc and tin for iron as a central metal of a heme of a horse-heart cytochrome c, and having a fluorescence excitation lifetime $\tau$ of $5.0 \times 10^{-11}$ s $< \tau \leq 8.0 \times 0^{-10}$ s.

Moreover, the present invention provides a protein photoelectric transducer including a metal-substituted bovine-heart cytochrome c formed by substituting a metal other than zinc and tin for iron as a central metal of a heme of a bovine-heart cytochrome c, and having a fluorescence excitation lifetime $\tau$ of $5.0 \times 10^{-11}$ s $< \tau \leq 8.0 \times 10^{-10}$ s.

Further, the present invention provides a protein photoelectric transducer including a protein having an amino-acid sequence formed by deletion, substitution, or addition of one or more amino acids in the amino-acid sequence of a horse-heart cytochrome c, including a metal other than zinc and tin, and having a fluorescence excitation lifetime $\tau$ of $5.0 \times 10^{-11}$ s $< \tau \leq /8.0 \times 10^{-10}$ s.

Moreover, the present invention provides a protein photoelectric transducer including a protein having an amino-acid sequence formed by deletion, substitution, or addition of one or more amino acids in the amino-acid sequence of a bovine-heart cytochrome c, including a metal other than zinc and tin, and having a fluorescence excitation lifetime $\tau$ of $5.0 \times 10^{-11}$ s $< \tau \leq 8.0 \times 10^{-10}$ s.

Further, the present invention provides a protein photoelectric transducer including a metal-substituted cytochrome c formed by substituting a metal other than zinc and tin for iron as a central metal of a heme of a mammalian cytochrome c, and having a fluorescence excitation lifetime $\tau$ of $5.0 \times 10^{-11}$ s $< \tau \leq 8.0 \times 10^{-10}$ s.

Moreover, the present invention provides a protein photoelectric transducer including a protein having an amino-acid sequence formed by deletion, substitution, or addition of one or more amino acids in the amino-acid sequence of a mammalian cytochrome c, including a metal other than zinc and tin, and having a fluorescence excitation lifetime $\tau$ of $5.0 \times 10^{-11}$ s $< \tau \leq 8.0 \times 10^{-10}$ s.

In the above-described protein photoelectric transducers, the above-described tin-substituted horse-heart cytochrome c, the above-described tin-substituted bovine-heart cytochrome c, the above-described proteins, the above-described tin-substituted cytochrome c, the above-described metal-substituted horse-heart cytochrome c, the above-described metal-substituted bovine-heart cytochrome c, and the above-described metal-substituted cytochrome c are typically immobilized on an electrode. As a material of the electrode, an inorganic material or an organic material may be used, and the material is selected as necessary. These protein photoelectric transducers each include a counter electrode in addition to the electrode on which the above-described tin-substituted horse-heart cytochrome c, the above-described tin-substituted bovine-heart cytochrome c, the above-described proteins, the above-described tin-substituted cytochrome c, the above-described metal-substituted horse-heart cytochrome c, the above-described metal-substituted bovine-heart cytochrome c, or the above-described metal-substituted cytochrome c is immobilized. The counter electrode is disposed to face the electrode.

In the invention configured as described above, the above-described tin-substituted horse-heart cytochrome c, the above-described tin-substituted bovine-heart cytochrome c, the above-described proteins, the above-described tin-substituted cytochrome c, the above-described metal-substituted horse-heart cytochrome c, the above-described metal-substituted bovine-heart cytochrome c, and the above-described metal-substituted cytochrome c hardly cause photolysis by light irradiation, and are capable of maintaining a photoelectric conversion function for a long time.

According to the present invention, the above-described tin-substituted horse-heart cytochrome c, the above-described tin-substituted bovine-heart cytochrome c, the above-described proteins, the above-described tin-substituted cytochrome c, the above-described metal-substituted horse-heart cytochrome c, the above-described metal-substituted bovine-heart cytochrome c, and the above-described metal-substituted cytochrome c have extremely high stability with respect to light irradiation. Accordingly, a protein photoelectric transducer capable of being stably used for a long time is achievable with use of any of them.

BRIEF DESCRIPTION OF THE DRAWINGS

**EP 2 472 627 A1**

[FIG. 1] FIG. 1 is a schematic diagram illustrating a measurement result of an ultraviolet-visible absorption spectrum of a tin-substituted horse-heart cytochrome c according to a first embodiment of the invention.

[FIG. 2] FIG. 2 is a schematic diagram illustrating a measurement result of an ultraviolet-visible absorption spectrum of a tin-substituted bovine-heart cytochrome c according to the first embodiment of the invention.

[FIG. 3] FIG. 3 is a schematic diagram illustrating a measurement result of an ultraviolet-visible absorption spectrum of a zinc-substituted horse-heart cytochrome c.

[FIG. 4] FIG. 4 is a schematic diagram illustrating a measurement result of an ultraviolet-visible absorption spectrum of a zinc-substituted bovine-heart cytochrome c.

[FIG. 5] FIG. 5 is a schematic diagram illustrating a measurement result of changes with time in the ultraviolet-visible absorption spectrum of the tin-substituted horse-heart cytochrome c according to the first embodiment of the invention.

[FIG. 6] FIG. 6 is a schematic diagram illustrating a measurement result of changes with time in the ultraviolet-visible absorption spectrum of the tin-substituted bovine-heart cytochrome c according to the first embodiment of the invention.

[FIG. 7] FIG. 7 is a schematic diagram illustrating a measurement result of changes with time in the ultraviolet-visible absorption spectrum of the zinc-substituted horse-heart cytochrome c.

[FIG. 8] FIG. 8 is a schematic diagram illustrating a measurement result of changes with time in the ultraviolet-visible absorption spectrum of zinc-substituted bovine-heart cytochrome c.

[FIG. 9] FIG. 9 is a schematic diagram illustrating an example of fitting of second-order reaction equations of photolysis reactions of the tin-substituted horse-heart cytochrome c and the tin-substituted bovine-heart cytochrome c according to the first embodiment of the invention.

[FIG. 10] FIG. 10 is a schematic diagram illustrating an example of fitting of second-order reaction equations of photolysis reactions of the zinc-substituted horse-heart cytochrome c and the zinc-substituted bovine-heart cytochrome c.

[FIG. 11] FIG. 11 is a plan view illustrating a protein-immobilized electrode used in a photocurrent generation experiment on a metal-substituted cytochrome c in the first embodiment of the invention.

[FIG. 12] FIG. 12 is a schematic diagram illustrating a measurement result of a photocurrent action spectrum of the protein-immobilized electrode illustrated in FIG. 11.

[FIG. 13] FIG. 13 is a schematic diagram illustrating an average Soret-band photocurrent value of the protein-immobilized electrode illustrated in FIG. 11.

[FIG. 14] FIG. 14 is a schematic diagram illustrating measurement results of ultraviolet-visible absorption spectra of various kinds of metal-substituted cytochromes c.

[FIG. 15] FIG. 15 is a schematic diagram illustrating measurement results of fluorescence spectra of various kinds of metal-substituted cytochromes c.

[FIG. 16] FIG. 16 is a schematic diagram illustrating integrated fluorescence intensities with respect to absorbance at a wavelength of 409 nm of the tin-substituted horse-heart cytochrome c and the zinc-substituted horse-heart cytochrome c.

[FIG. 17] FIG. 17 is a schematic diagram illustrating integrated fluorescence intensities with respect to absorbance at a wavelength of 409 nm of the tin-substituted bovine-heart cytochrome c, the zinc-substituted bovine-heart cytochrome c, and the zinc-substituted horse-heart cytochrome c.

[FIG. 18] FIG. 18 is a schematic diagram illustrating a protein photoelectric transducer according to a second embodiment of the invention.

[FIG. 19] FIG. 19 is a schematic diagram illustrating a first example of usage of the protein photoelectric transducer according to the second embodiment of the invention.

[FIG. 20] FIG. 20 is a schematic diagram illustrating a second example of usage of the protein photoelectric transducer according to the second embodiment of the invention.

[FIG. 21] FIG. 21 is a schematic diagram illustrating a third example of usage of the protein photoelectric transducer according to the second embodiment of the invention.

[FIG. 22] FIG. 22 is a sectional view illustrating a liquid-uncontacting all-solid-state protein photoelectric transducer according to a third embodiment of the invention.

[FIG. 23] FIG. 23 is an enlarged sectional view of a main part of the liquid-uncontacting all-solid-state protein photoelectric transducer illustrated in FIG. 22.

[FIG. 24] FIG. 24 is a schematic diagram for describing an operation of the liquid-uncontacting all-solid-state protein photoelectric transducer according to the third embodiment of the invention.

[FIG. 25] FIG. 25 is a plan view for describing a method of manufacturing a liquid-uncontacting all-solid-state protein photoelectric transducer according to an example of the invention.

[FIG. 26] FIG. 26 is a plan view for describing the method of manufacturing the liquid-uncontacting all-solid-state protein photoelectric transducer according to the example of the invention.

[FIG. 27] FIG. 27 is a sectional view illustrating the liquid-uncontacting all-solid-state photoelectric transducer according to the example of the invention.

[FIG. 28] FIG. 28 is a schematic diagram illustrating a measurement result of a photocurrent action spectrum of the liquid-uncontacting all-solid-state photoelectric transducer.

[FIG. 29] FIG. 29 is a schematic diagram illustrating a measurement result of background current-voltage characteristics of the liquid-uncontacting all-solid-state protein photoelectric transducer.

[FIG. 30] FIG. 30 is a schematic diagram illustrating a measurement result of current-voltage characteristics of the liquid-uncontacting all-solid-state protein photoelectric transducer.

[FIG. 31] FIG. 31 is a schematic diagram illustrating measurement results of photocurrent action spectra of the liquid-uncontacting all-solid-state protein photoelectric transducer and a liquid protein photoelectric transducer.

[FIG. 32] FIG. 32 is a schematic diagram illustrating measurement results of photocurrent action spectra of the liquid-uncontacting all-solid-state protein photoelectric transducer and the liquid protein photoelectric transducer, where the spectra are normalized for a peak value of a photocurrent to be 1.

[FIG. 33] FIG. 33 is a schematic diagram illustrating measurement results of photo-degradation curves of the liquid-uncontacting all-solid-state protein photoelectric transducer and the liquid protein photoelectric transducer.

[FIG. 34] FIG. 34 is a schematic diagram illustrating measurement results of photo-degradation curves of the liquid-uncontacting all-solid-state protein photoelectric transducer and the liquid protein photoelectric transducer, where the curves are normalized for a peak value of a photocurrent at the beginning of irradiation to be 1.

[FIG. 35] FIG. 35 is a schematic diagram illustrating a measurement result of frequency response of the liquid protein photoelectric transducer.

[FIG. 36] FIG. 36 is a schematic diagram illustrating a measurement result of frequency response of the liquid-uncontacting all-solid-state protein photoelectric transducer.

[FIG. 37] FIG. 37 is a schematic diagram illustrating a measurement result of a photocurrent action spectrum of a liquid-uncontacting all-solid-state protein photoelectric transducer according to an example of the invention.

[FIG. 38] FIG. 38 is a schematic diagram illustrating a measurement result of a photo-degradation curve of the liquid-uncontacting all-solid-state protein photoelectric transducer according to the example of the invention.

[FIG. 39] FIG. 39 is a schematic diagram illustrating a measurement result of an ultraviolet-visible absorption spectrum of a zinc-substituted horse-heart cytochrome c.

[FIG. 40] FIG. 40 is a schematic diagram illustrating a measurement result of an ultraviolet-visible absorption spectrum of the zinc-substituted horse-heart cytochrome c in an argon atmosphere.

[FIG. 41] FIG. 41 is a schematic diagram illustrating a measurement result of an absorption spectrum of the zinc-substituted horse-heart cytochrome c with addition of a radical-trapping agent.

BEST MODE(S) FOR CARRYING OUT THE INVENTION

Best modes for carrying out the invention (hereinafter referred to as "embodiments") will be described below. It is to be noted that description will be given in the following order.

1. First Embodiment (Tin-substituted cytochrome c)
2. Second Embodiment (Protein photoelectric transducer)
3. Third Embodiment (Liquid-uncontacting all-solid-state protein photoelectric transducer)
4. Fourth Embodiment (Metal-substituted cytochrome c)
5. Fifth Embodiment (Protein photoelectric transducer)

(1. First Embodiment)

[Tin-substituted cytochrome c]

Table 1 illustrates amino-acid sequences (one-letter code) of a horse-heart cytochrome c (represented by CYC_HORSE) and a bovine-heart cytochrome c (represented by CYC_BOVIN). As illustrated in Table 1, only 3 amino-acid residues in all 104 amino-acid residues are different between the bovine-heart cytochrome c and the horse-heart cytochrome c. The bovine-heart cytochrome c contains the amino-acid residues Ser48, Gly61, and Gly90 instead of Thr48, Lys61, and Thr90 of the horse-heart cytochrome c, respectively.

[Table 1]

sp:CYC_HORSE 001    MGDVEKGKKIFVQKCAQCHTVEKGGKHKTG

(continued)

| | |
|---|---|
| sp:CYC_BOVIN_001 | MGDVEKGKKIFVQKCAQCHTVEKGGKHKTG 48 |
| sp:CYC HORSE 031 | PNLHGLFGRKTGQAPGFTYTDANKNKGITW |
| sp:CYC_BOVIN_031 | PNLHGLFGRKTGQAPGFSYTDANKNKGITW 61                                                                     90 |
| sp:CYC_HORSE_061 | KEETLMEYLENPKKYIPGTKMIFAGIKKKT |
| sp:CYC_BOVIN_061 | GEETLMEYLENPKKYIPGTKMIFAGIKKKG |
| sp:CYC_HORSE_091 | EREDLIAYLKKATNE 104 |
| sp:CYC_BOVIN_091 | EREDLIAYLKKATNE 104 |

It is known that in the bovine-heart cytochrome c, a protein part has higher stability with respect to heat and a denaturant (guanidinium hydrochloride), compared to the horse-heart cytochrome c (refer to NPTLs 1 and 2). Table 2 illustrates denaturation midpoint temperatures $T_{1/2}$ and denaturation midpoint concentrations $[Gdn\text{-}HCl]_{1/2}$ of the horse-heart cytochrome c and the bovine-heart cytochrome c. The denaturation midpoint temperature $T_{1/2}$ is a temperature at which denatured proteins constitute a half (1/2) of all proteins in a system. Moreover, the denaturation midpoint concentration $[Gdn\text{-}HCl]_{1/2}$ is a concentration of guanidinium hydrochloride (Gdn-HCl) at which denatured proteins constitute a half (1/2) of all proteins in the system. The higher the values of $T_{1/2}$ and $[Gdn\text{-}HCl]_{1/2}$ are, the higher the stability is.

[Table 2]

| | $T_{1/2}$ (°C) | $[Gdn\text{-}HCl]_{1/2}$ (M) |
|---|---|---|
| Horse-heart cytochrome c | 85 | 2.50 |
| Bovine-heart cytochrome c | 85 | 2.61 |

(Preparation of tin-substituted cytochrome c)

The tin-substituted horse-heart cytochrome c and the tin-substituted bovine-heart cytochrome c were prepared as follows. For a comparison experiment, a zinc-substituted horse-heart cytochrome c and a zinc-substituted bovine-heart cytochrome c were also prepared.

As a horse-heart cytochrome c and a bovine-heart cytochrome c, a horse-heart cytochrome c and a bovine-heart cytochrome c manufactured by Sigma were used.

Although a method of preparing the tin-substituted horse-heart cytochrome c will be mainly described below, methods of preparing the tin-substituted bovine-heart cytochrome c, the zinc-substituted horse-heart cytochrome c, and the zinc-substituted bovine-heart cytochrome c are similar to the method of preparing the tin-substituted horse-heart cytochrome c. It is to be noted that a protein having an amino-acid sequence formed by deletion, substitution, or addition of one or more amino acids in the amino-acid sequence of the horse-heart cytochrome c or the bovine-heart cytochrome c, and including tin is allowed to be prepared in a like manner by appropriately using a technique such as random mutation or chemical modification.

Iron as a central metal of a heme is removed from the horse-heart cytochrome c by mixing 6 mL of 70% hydrofluoric acid/pyridine into 100 mg of horse-heart cytochrome c powder, and incubating a resultant mixture at room temperature for 10 minutes. Next, 9 mL of a 50 mM ammonium acetate buffer solution (pH 5.0) is mixed into the horse-heart cytochrome c from which iron is removed in such a manner, and after a reaction is completed, the horse-heart cytochrome c is subjected to gel filtration column chromatography (column volume: 150 mL; resin: Sephadex G-50; developing solvent: 50 mM sodium acetate buffer solution (pH 5.0)) to obtain a metal-free horse-heart cytochrome c without the central metal.

A solution of the metal-free horse-heart cytochrome c is condensed as much as possible, and glacial acetic acid is mixed into the solution, thereby allowing the solution to have a pH of 2.5 (±0.05). Approximately 25 mg of tin chloride powder is mixed into a solution obtained in such a manner, and the solution is subjected to incubation at 50°C for 30 minutes under protection from light. When zinc acetate or zinc chloride is mixed instead of tin chloride in this process, a zinc-substituted product is obtained. The incubation is continued while an ultraviolet-visible absorption spectrum is measured every 10 minutes until a ratio between an absorption peak at a wavelength of 280 nm corresponding to a protein and an absorption peak at a wavelength of 408 nm corresponding to a tin-porphyrin becomes constant.

The following procedures are all performed under protection from light. After a saturated sodium monohydrogen diphosphate solution is mixed into the above-described solution which is finally obtained to allow the solution to have a neutral pH (6.0<), an exchange of the buffer solution to a 10 mM sodium phosphate buffer solution (pH 7.0) is performed. After that, a monomer fraction is recovered by cation exchange column chromatography (column volume: 40 mL; resin: SP-Sephadex Fast Flow; elution: a linear concentration gradient of 10 to 150 mM sodium phosphate buffer solution (pH 7.0)). Thus, the tin-substituted horse-heart cytochrome c is prepared.

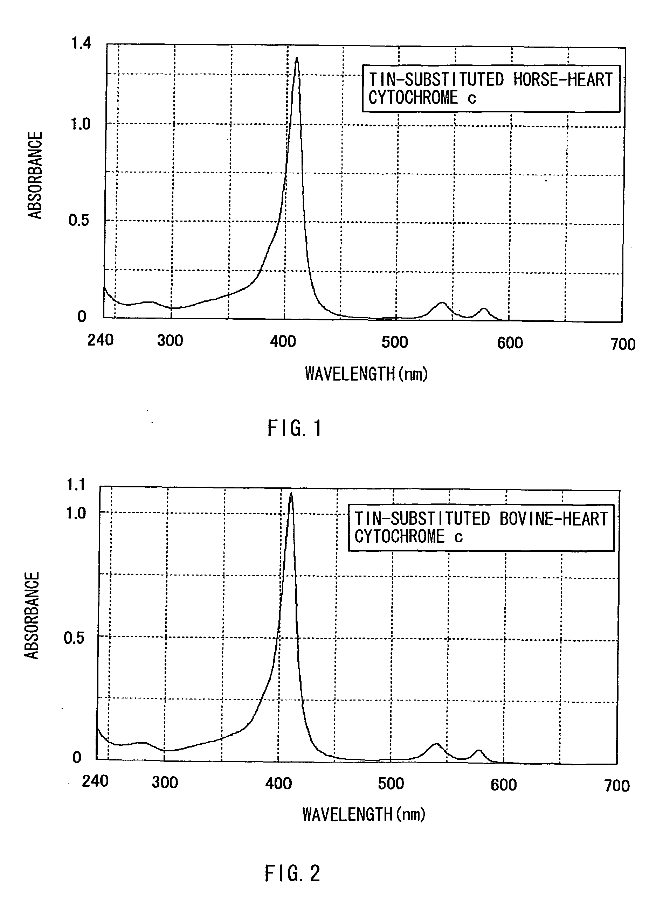

Measurement results of ultra-violet-visible absorption spectra of the tin-substituted horse-heart cytochrome c, the tin-substituted bovine-heart cytochrome c, the zinc-substituted horse-heart cytochrome c, and the zinc-substituted bovine-heart cytochrome c which are prepared in the above-described manner are illustrated in FIGs. 1 to 4. Hereinafter, if necessary, the tin-substituted horse-heart cytochrome c, the tin-substituted bovine-heart cytochrome c, the zinc-substituted horse-heart cytochrome c, and zinc-substituted bovine-heart cytochrome c are abbreviated to Snhhc, Snbvc, Znhhc, and Znbvc, respectively. As illustrated in FIGs. 1 to 4, while the zinc-substituted horse-heart cytochrome c and the zinc-substituted bovine-heart cytochrome c have absorption maximums at wavelengths of 280 nm, 346 nm, 423 nm, 550 nm, and 584 nm, the tin-substituted horse-heart cytochrome c and the tin-substituted bovine-heart cytochrome c have absorption maximums at wavelengths of 280 nm, 409 nm, 540 nm, and 578 nm, and do not have the $\delta$ band (around 346 nm).

(Decomposition experiments by light irradiation on metal-substituted cytochromes c)

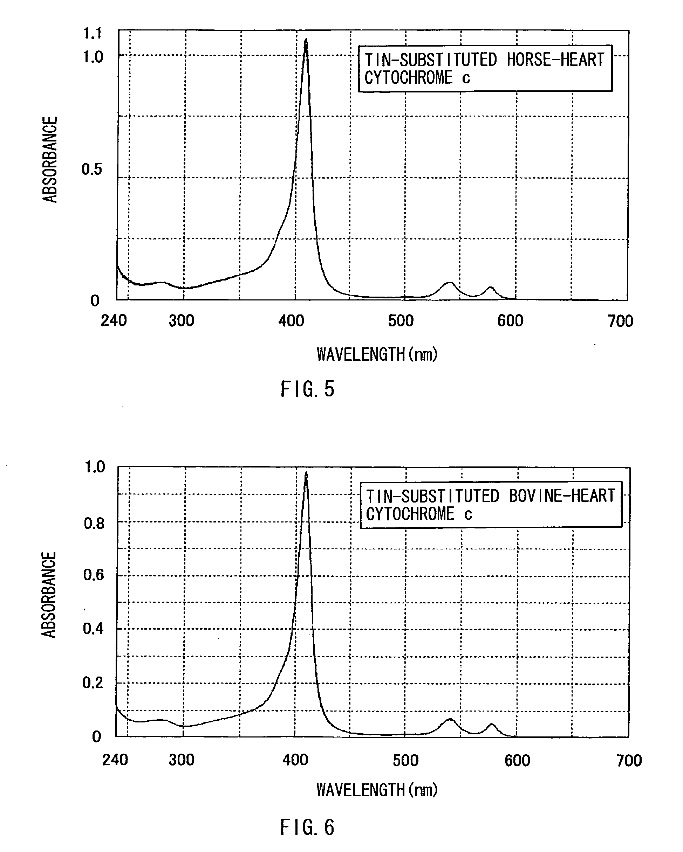

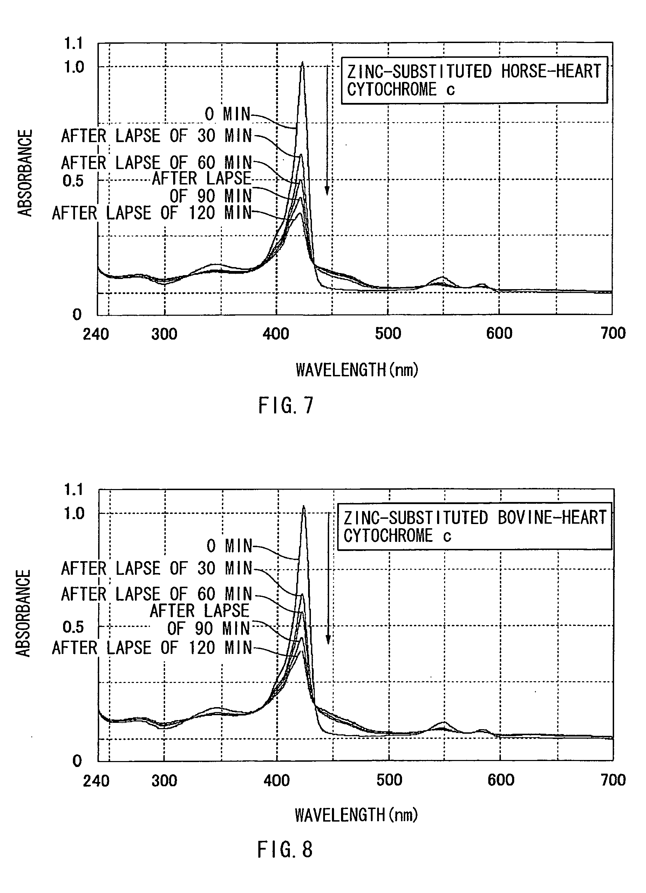

Decomposition experiments by light irradiation on the above-described four kinds of metal-substituted cytochromes c, i.e., the tin-substituted horse-heart cytochrome c, the tin-substituted bovine-heart cytochrome c, the zinc-substituted horse-heart cytochrome c, and the zinc-substituted bovine-heart cytochrome c were performed in the following manner. One milliliter of an approximately 4 $\mu$M metal-substituted cytochrome c (dissolved in a 10 mM sodium phosphate buffer solution (pH 7.0)) was put into a cuvette, and zinc-substituted products and tin-substituted products were irradiated with light with a wavelength of 420 nm (an intensity of 1255 $\mu$W) and light with a wavelength of 408 nm (an intensity of 1132 $\mu$W), respectively, in a dark room at room temperature. Ultraviolet-visible absorption spectra of the zinc-substituted products and the tin-substituted products in a wavelength range of 240 nm to 700 nm were measured every 30 minutes. Results are illustrated in FIGs. 5 to 8. An arrow in each of FIGs. 7 and 8 indicates a spectrum change direction.

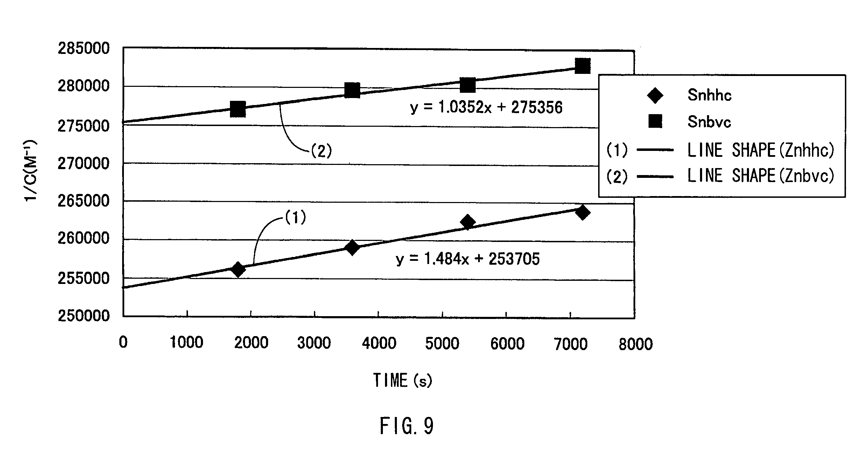

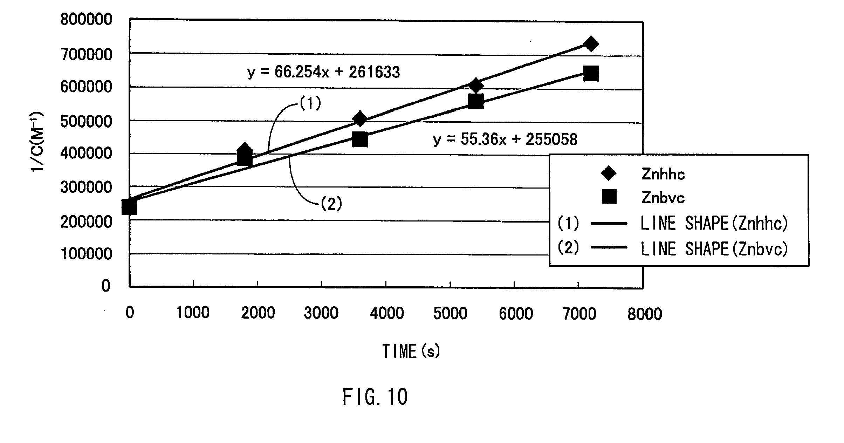

It is apparent from FIGs. 7 and 8 that the zinc-substituted horse-heart cytochrome c and the zinc-substituted bovine-heart cytochrome c are rapidly photolyzed with time. On the other hand, it is apparent from FIGs. 5 and 6 that spectra of the tin-substituted horse-heart cytochrome c and the tin-substituted bovine-heart cytochrome c after a lapse of time almost overlap initial spectra thereof, respectively, and photolysis hardly occurs even after a lapse of time. A concentration (M) was determined from absorbance at the Soret band (zinc (Zn): 423 nm, tin (Sn): 409 nm) in the ultraviolet-visible absorption spectra illustrated in FIGs. 5 to 8 with use of a millimolar absorption coefficient $\varepsilon$ (Zn: 243000 $M^{-1}cm^{-1}$, Sn: 267000 $M^{-1}cm^{-1}$, values are quoted from NPTL 3), and an inverse of the concentration was plotted with respect to time (second (s)), and a photolysis rate constant k was determined from a gradient of an obtained line. FIG. 9 illustrates a plot of the inverses (1/C) of the concentrations of the tin-substituted horse-heart cytochrome c and the tin-substituted bovine-heart cytochrome c with respect to time (t), and FIG. 10 illustrates a plot of the inverses (1/C) of the concentrations of the zinc-substituted horse-heart cytochrome c and the zinc-substituted bovine-heart cytochrome c with respect to time (t). In FIGs. 9 and 10, a straight line is a fitting curve of a second-order reaction equation (1/C=kt+1/Co). In this case, $C_0$ is an initial concentration. The gradient of the straight line is the photolysis rate constant k. In a primary equation representing the straight line illustrated in FIGs. 9 and 10, t is represented by x, and 1/C is represented by y.

The photolysis rate constants k of the above-described four kinds of metal-substituted cytochromes c were determined from an average of values obtained from two experiments. As a result, the photolysis rate constants k of the tin-substituted horse-heart cytochrome c, the tin-substituted bovine-heart cytochrome c, the zinc-substituted horse-heart cytochrome c, and the zinc-substituted bovine-heart cytochrome c were $1.39\pm0.13$ $M^{-1}s^{-1}$, $0.90\pm0.20$ $M^{-1}s^{-1}$, $67.2\pm1.4$ $M^{-1}s^{-1}$, and $56.1\pm1.0$ $M^{-1}s^{-1}$, respectively. It is apparent from the results that both of the tin-substituted horse-heart cytochrome c and the tin-substituted bovine-heart cytochrome c have 50 to 60 times as slow a photolysis rate as those of the zinc-substituted horse-heart cytochrome c and the zinc-substituted bovine-heart cytochrome c, and are extremely stable with respect to light irradiation. Moreover, it is apparent that in both of the zinc-substituted products and the tin-substituted products, the bovine-heart cytochrome c has 1.2 to 1.5 times as slow a photolysis rate as that of the horse-heart cytochrome c, and is more stable with respect to light irradiation. In particular, the tin-substituted bovine-heart cytochrome c is 75 times as stable with respect to light irradiation as the zinc-substituted horse-heart cytochrome c used in PTL 1.

(Photocurrent generation experiments on metal-substituted cytochromes c)

A protein-immobilized electrode used in a photocurrent generation experiment was formed in the following manner.

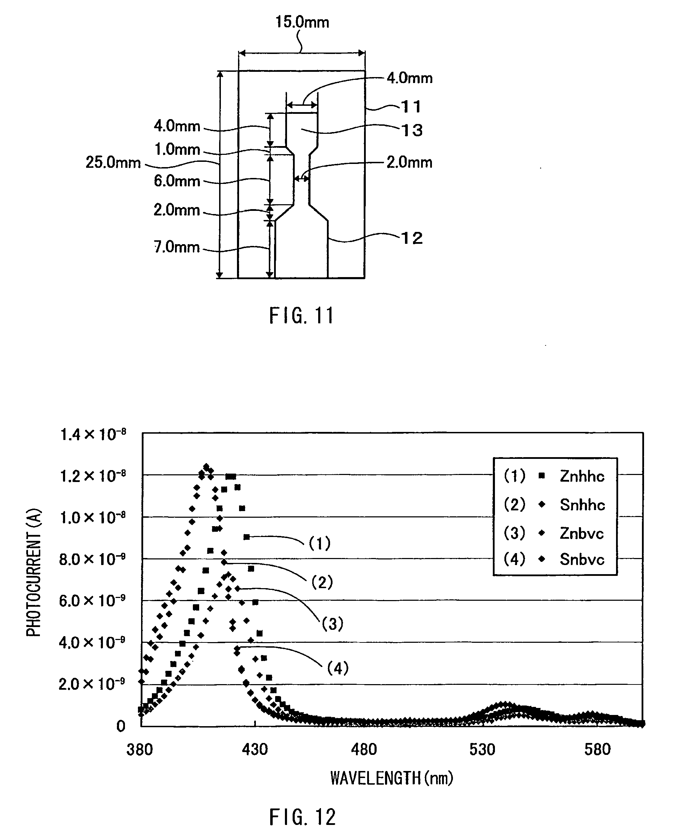

As illustrated in FIG. 11, an ITO electrode 12 with a predetermined shape was formed on a glass substrate 11 with a size of 15.0 mmx25.0 mm and a thickness of 1 mm. The dimensions of each components of the ITO electrode 12 were as illustrated in FIG. 11. The thickness of the ITO electrode 12 was 100 nm. The ITO electrode 12 served as a working electrode. The size of an irradiated region 13 was 4.0 mmx4.0 mm. A drop was formed on the ITO electrode 12 in the irradiated region 13 with use of 10 $\mu$L of a 50 $\mu$M metal-substituted cytochrome c solution (dissolved in 10 mM Tris-Hcl (pH 8.0)), and was left at 4˚C for 2 days. Thus, the protein-immobilized electrode was formed.

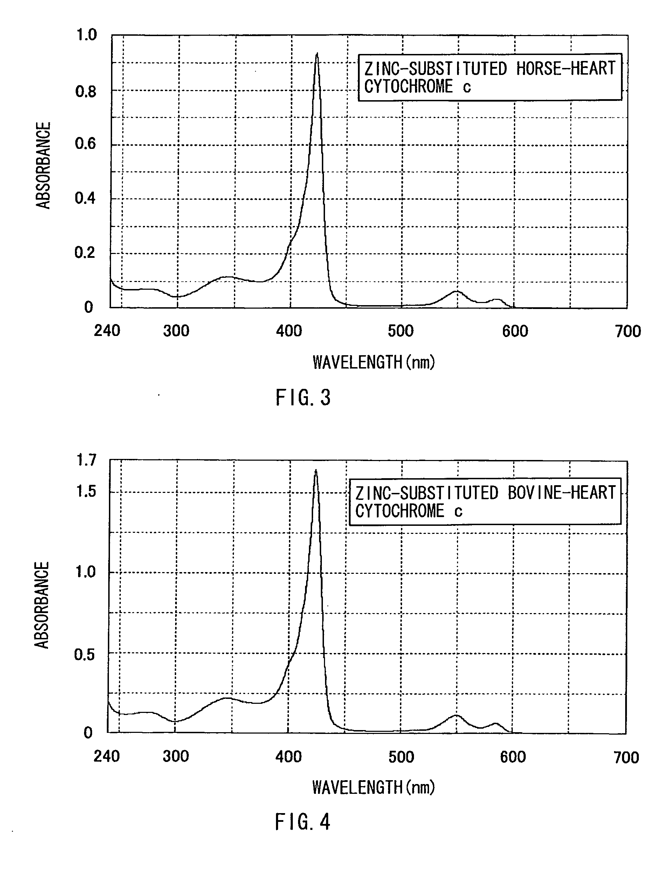

The protein-immobilized electrode was immersed in 27 mL of a 10 mM sodium phosphate buffer solution (pH 7.0) including 0.25 mM potassium ferrocyanide, and a platinum mesh as a counter electrode, and a silver-silver chloride electrode as a reference electrode were used, and photocurrent action spectra in a wavelength range of 380 nm to 600 nm were measured with use of a photocurrent measuring device illustrated in FIG. 4 of PTL 1, where a potential for the silver-silver chloride electrode was 120 mV. In the measurement, a hold time was 900 seconds, a measurement time was 60 seconds, a current range was 10 nA, a filter frequency was 30 Hz, and time resolution was 50 ms. Five electrodes made of each of four kinds of metal-substituted cytochromes c were formed to perform the measurement.

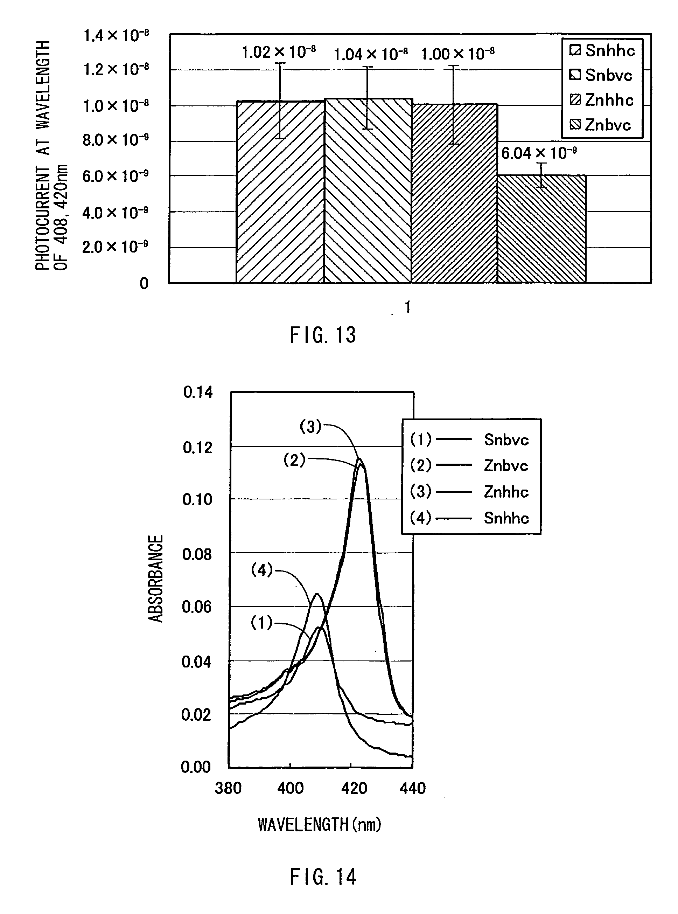

The obtained photocurrent action spectra are illustrated in FIG. 12. The maximums of the photocurrent action spectra were observed at 408 nm, 540 nm, and 578 nm as in the case of solution absorption spectra. It is considered from FIG. 12 that as a ratio of intensity at the Soret band (408 nm) to intensity at the Q band (540 nm) was 10:1, the photocurrent generation mechanisms of the tin-substituted horse-heart cytochrome c and the tin-substituted bovine-heart cytochrome c were of a hole transfer type as in the case of the zinc-substituted horse-heart cytochrome c (refer to NPTL 4). FIG. 13 illustrates a graph of average photocurrent values at the Soret band (with a sample number of 5). It is apparent from FIG. 13 that both of the tin-substituted horse-heart cytochrome c and the tin-substituted bovine-heart cytochrome c generate a photocurrent (10 nA) equal to a photocurrent generated by the zinc-substituted horse-heart cytochrome c.

(Fluorescence quantum yields of metal-substituted cytochromes c)

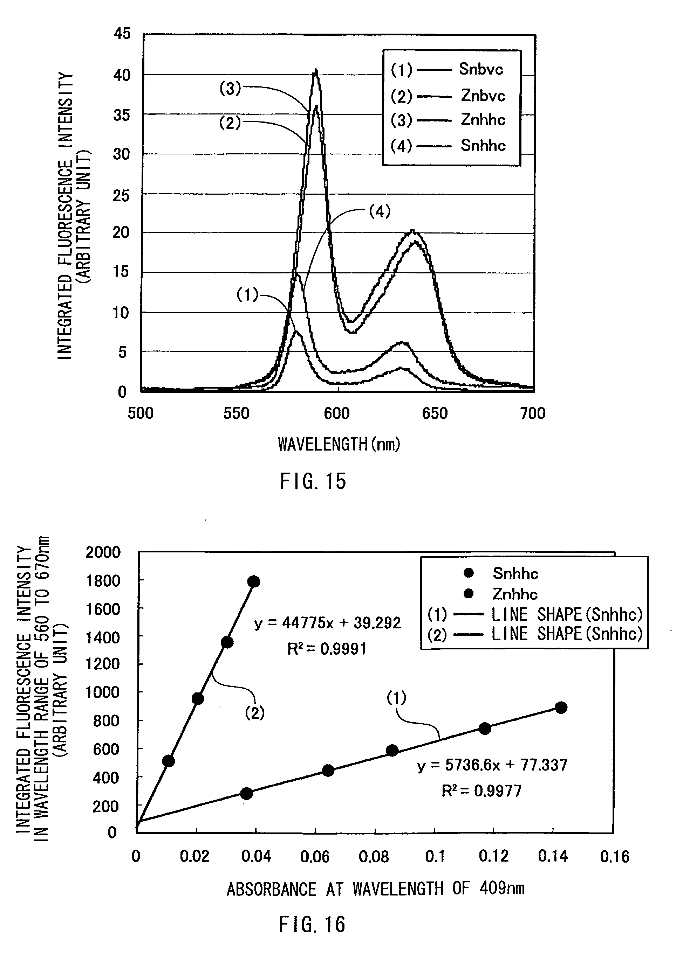

Dilute solutions of the metal-substituted cytochromes c with different concentrations were prepared, and ultra-violet-visible absorption spectra in a wavelength range of 380 nm to 440 nm and fluorescence spectra (at an excitation wavelength of 409 nm) in a wavelength range of 500 nm to 700 nm were measured. The results are illustrated in FIGs. 14 and 15.

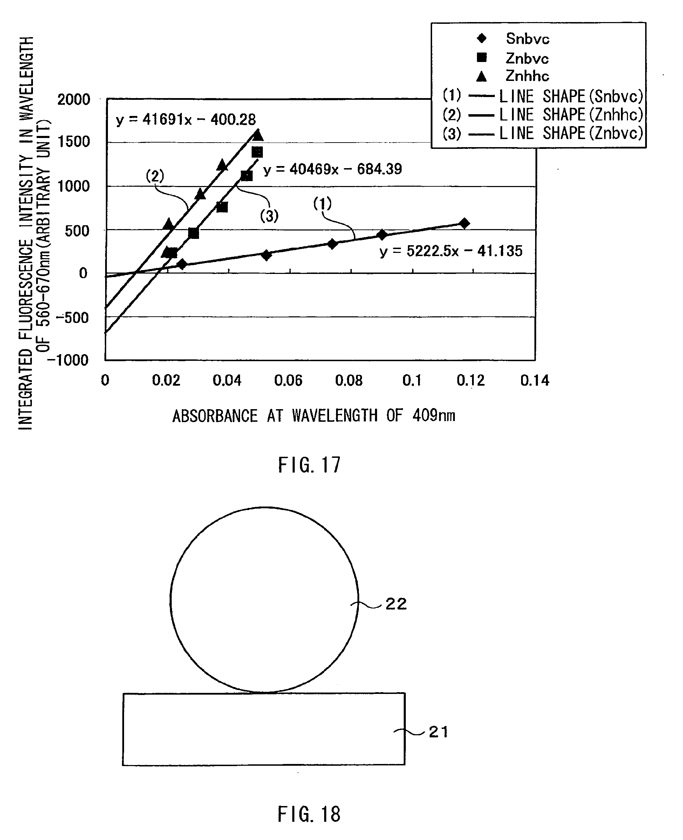

As illustrated in FIGs. 16 and 17, a horizontal axis (an x axis) indicates absorbance at a wavelength of 409 nm, and a vertical axis (a y axis) indicates integrated fluorescence intensity in a wavelength range of 550 nm to 670 nm, and each data was plotted to draw a straight-line approximation curve. The gradient of a straight line obtained in such a manner is a fluorescence quantum yield. In the fluorescence spectra illustrated in FIG. 15, an area between wavelengths of 550 nm and 670 nm was integrated fluorescence intensity (arbitrary unit (a.u.)). The gradient of a straight line of the zinc-substituted horse-heart cytochrome c, that is, the relative fluorescence quantum yield $\phi$ of each metal-substituted cytochrome c in the case where the fluorescence quantum yield was 1.0 was determined. Results are illustrated in Table 3. It is apparent from Table 3 that fluorescence intensities of the tin-substituted products are approximately 1/7 to 1/8 of those of the zinc-substituted products. It is considered that the short lifetime of an excited electron in the zinc-substituted products inhibits radical generation during light irradiation to contribute to stabilization.

[Table 3]

| Protein | Fluorescence quantum yield $\phi$ |
|---|---|
| Zinc-substituted horse-heart cytochrome c | 1.0 |
| Zinc-substituted bovine-heart cytochrome c | 0.97 |
| Tin-substituted horse-heart cytochrome c | 0.13 |
| Tin-substituted bovine-heart cytochrome c | 0.13 |

As described above, in the first embodiment, both of the tin-substituted horse-heart cytochrome c and the tin-substituted bovine-heart cytochrome c have extremely high stability with respect to light irradiation, compared to the zinc-substituted horse-heart cytochrome c and the zinc-substituted bovine-heart cytochrome c. Therefore, a novel protein photoelectric transducer capable of being stably used for a long time is achievable with use of the tin-substituted horse-heart cytochrome c or the tin-substituted bovine-heart cytochrome c. The protein photoelectric transducer is allowed to be used for a photosensor, an image pickup element, or the like. Moreover, in both of the tin-substituted horse-heart cytochrome c and the tin-substituted bovine-heart cytochrome c, the wavelength of the light absorption maximum is 409 nm, which is close to the wavelength, 405 nm, of a semiconductor laser presently used in an optical disk system capable of high-density recording. Therefore, instead of an optical disk, a novel memory is achievable with use of, for example, a medium formed by spreading the tin-substituted horse-heart cytochrome c or the tin-substituted bovine-heart cytochrome c over a substrate. Moreover, the diameters of the tin-substituted horse-heart cytochrome c and the tin-substituted bovine-heart cytochrome c are extremely small, approximately 2 nm; therefore, compared to related art, the number of elements allowed to be mounted per unit area of the substrate is allowed to be remarkably increased. Therefore, a high-definition photosensor, image pickup element, or the like is achievable, or a high-capacity memory is achievable.

(2. Second Embodiment)

[Protein photoelectric transducer]

In a second embodiment, a protein photoelectric transducer using the tin-substituted horse-heart cytochrome c or the tin-substituted bovine-heart cytochrome c according to the first embodiment will be described.

FIG. 18 illustrates a protein photoelectric transducer according to the first embodiment, specifically a protein-immobilized electrode.
As illustrated in FIG. 18, in the protein photoelectric transducer, a protein 22 made of the tin-substituted horse-heart cytochrome c or the tin-substituted bovine-heart cytochrome c is immobilized on an electrode 21. The protein 22 is preferably immobilized to allow a tin-porphyrin of the tin-substituted horse-heart cytochrome c or the tin-substituted bovine-heart cytochrome c to face the electrode 21; however, the invention is not limited thereto.

Although one molecule of the protein 22 is illustrated in FIG. 18, the number of molecules of the protein 22 immobilized on the electrode 21 is determined as necessary, and typically, a plurality of molecules of the protein 22 are immobilized as a monomolecular film or a multimolecular film. Moreover, although the electrode 21 illustrated in FIG. 18 has a flat surface shape, the electrode 21 may have any surface shape, for example, any one of a surface with recesses, a surface with projections, a surface with recesses and projections, and the like, and the protein 22 is allowed to be easily immobilized on any surface shape.

As a material of the electrode 21, for example, an inorganic material typified by a metal such as gold, platinum, or silver, or a metal oxide or glass such as ITO (indium-tin oxide), FTO (fluorine-doped tin oxide) or Nesa glass ($SnO_2$ glass) is allowed to be used. As the material of the electrode 21, an organic material may be used. Examples of the organic material include conductive polymers (such as polythiophene, polypyrrole, polyacetylene, polydiacetylene, polyparaphenylene, and polyparaphenylene sulfide) and charge-transfer complexes (for example, TTF-TCNQ) containing a tetrathiafulvalene derivative (such as TTF, TMTSF, or BEDT-TTF). In the case where light enters the protein 22 through the electrode 21, the electrode 21 is preferably transparent to light used for photoexcitation of the protein 22. For example, the electrode 21 is made of a conductive material transparent to light used for photoexcitation of the protein 22, for example, ITO, FTO, or Nesa glass, or is configured of an extremely thin metal film or the like allowing light to pass therethrough.

The protein photoelectric transducer includes a counter electrode in addition to the protein-immobilized electrode formed by immobilizing the protein 22 on the electrode 21. The counter electrode is disposed to face the protein-immobilized electrode with a space in between. As a material of the counter electrode, for example, an inorganic material typified by a metal such as gold, aluminum, palladium, silver, or chromium, or a metal oxide or glass such as ITO (indium-tin oxide), FTO (fluorine-doped tin oxide) or Nesa glass ($SnO_2$ glass) is allowed to be used. As the material of the counter electrode, a conductive polymer (polythiophene, polypyrrole, polyacetylene, polydiacetylene, polyparaphenylene, or polyparaphenylene sulfide), or a charge-transfer complex (for example, TTF-TCNQ) containing a tetrathiafulvalene derivative (such as TTF, TMTSF, or BEDT-TTF) may be used. To allow the entire or almost entire protein 22 immobilized on the electrode 21 to be irradiated with light through the counter electrode, the counter electrode is preferably transparent to light used for photoexcitation of the protein 22. For example, the counter electrode is made of a conductive material transparent to light used for photoexcitation of the protein 22, for example, ITO, FTO, or Nesa glass, or is configured of an extremely thin metal film or the like allowing light to pass therethrough.

This protein photoelectric transducer is allowed to operate either in a solution (an electrolytic solution or a buffer solution) or in a dry environment unless a photoelectric conversion function and an electron transfer function of the protein 22 are impaired. In the case where the protein photoelectric transducer operates in the electrolytic solution or the buffer solution, typically, the counter electrode is disposed to face the protein-immobilized electrode with a space in between, and the protein-immobilized electrode and the counter electrode are immersed in the electrolytic solution or the buffer solution. As an electrolyte (or a redox species) of the electrolytic solution, an electrolyte causing an oxidation reaction in the protein-immobilized electrode and an reduction reaction in the counter electrode, or an electrolyte causing a reduction reaction in the protein-immobilized electrode and an oxidation reaction in the counter electrode is used. More specifically, as the electrolyte (or the redox species), for example, $K_4[Fe(CN)_6]$ or $[Co(NH_3)_6]Cl_3$ is used. In the case where the protein photoelectric transducer operates in a dry environment, typically, for example, a solid electrolyte not absorbing the protein 22, more specifically, for example, a wet solid electrolyte such as agar or polyacrylamide gel is sandwiched between the protein-immobilized electrode and the counter electrode, and a sealing wall is preferably provided around the solid electrolyte to prevent the solid electrolyte from drying. In these cases, when light is received by a light-sensitive section made of the protein 22, a photocurrent is allowed to be obtained with polarity based on a difference between natural electrode potentials of the protein-immobilized electrode and the counter electrode.

[Usage of protein photoelectric transducer]

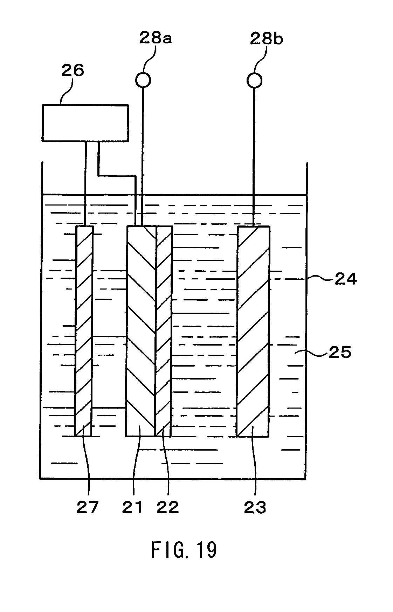

FIG. 19 illustrates a first example of usage of the protein photoelectric transducer. As illustrated in FIG. 19, in the first example, the protein-immobilized electrode formed by immobilizing the protein 22 on the electrode 21 and a counter electrode 23 are disposed to face each other. The protein-immobilized electrode and the counter electrode 23 are immersed in an electrolytic solution 25 contained in a container 24. As the electrolytic solution 25, an electrolytic solution not impairing functions of the protein 22 is used. Moreover, as an electrolyte (or a redox species) of the electrolytic solution 25, an electrolyte causing an oxidation reaction in the protein-immobilized electrode and a reduction reaction in the counter electrode 23, or an electrolyte causing a reduction reaction in the protein-immobilized electrode and an oxidation reaction in the counter electrode 23 is used.

To perform photoelectric conversion in the protein photoelectric transducer, while a bias voltage is applied to the protein-immobilized electrode with respect to a reference electrode 27 by a bias supply 26, the protein 22 of the protein-immobilized electrode is irradiated with light. This light is a single-color light capable of inducing photoexcitation of the protein 22 or light having a component of the light. In this case, when at least one of the bias voltage applied to the protein-immobilized electrode, the intensity of the light to be applied, and the wavelength of the light to be applied is adjusted, the magnitude and/or polarity of a photocurrent flowing through the transducer is allowed to be changed. The photocurrent is extracted from terminals 28a and 28b to the outside.

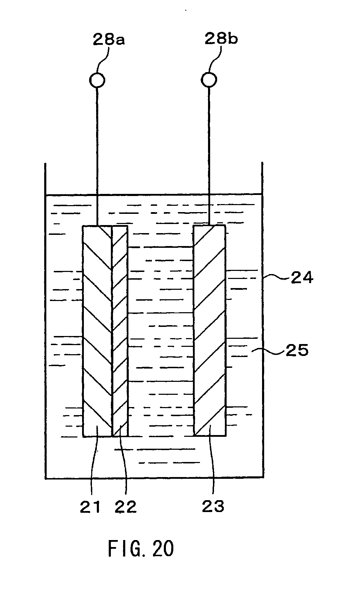

FIG. 20 illustrates a second example of usage of the protein photoelectric transducer. As illustrated in FIG. 20, in the second example, unlike the first example, instead of generating a bias voltage with use of the bias supply 26, a difference between the natural electrode potentials of the protein-immobilized electrode and the counter electrode 23 is used as a bias voltage. In this case, it is not necessary to use the reference electrode 27. Therefore, this protein photoelectric transducer is a two-electrode system using the protein-immobilized electrode and the counter electrode 23. In the second example, points other than the above-described point are the same as those in the first example.

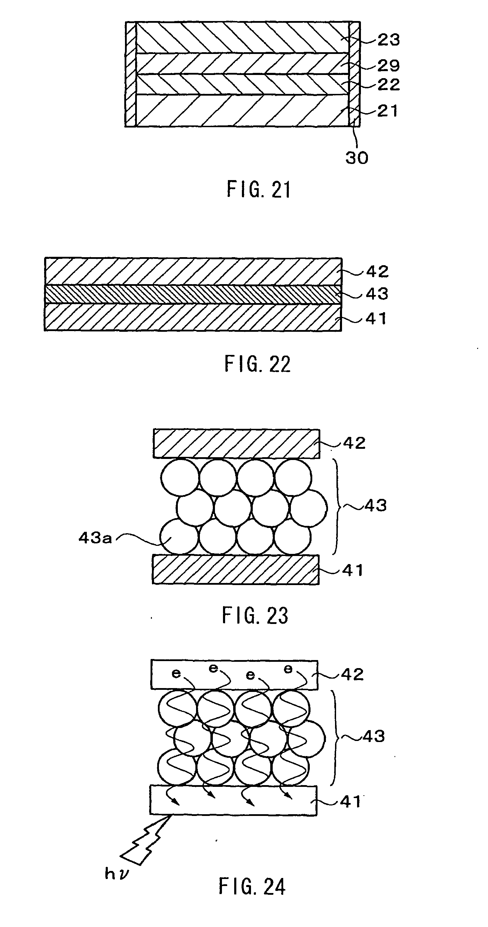

FIG. 21 illustrates a third example of usage of the protein photoelectric transducer. Whereas the protein photoelectric transducers of the first and second examples operate in a solution, the protein photoelectric transducer of this example is allowed to operate in a dry environment. As illustrated in FIG. 21, in this protein photoelectric transducer, a solid electrolyte 29 is sandwiched between the protein-immobilized electrode and the counter electrode 23. Moreover, a sealing wall 30 is provided around the solid electrolyte 29 to prevent the solid electrolyte 29 from drying. As the solid electrolyte 29, a solid electrolyte not impairing the functions of the protein 22 is used, and more specifically, agar, polyacrylamide gel, or the like which does not absorb proteins is used. To perform photoelectric conversion in this protein photoelectric transducer, the protein 22 of the protein-immobilized electrode is irradiated with light with use of a difference between the natural electrode potentials of the protein-immobilized electrode and the counter electrode 23 as a bias voltage. This light is single-color light capable of inducing photoexcitation of the protein 22 or light having a component of the light. In this case, when at least one of the difference between the natural electrode potentials of the protein-immobilized electrode and the counter electrode 23, the intensity of the light to be applied, and the wavelength of the light to be applied is adjusted, the magnitude and/or polarity of a photocurrent flowing through the transducer is allowed to be changed. In the third example, points other than the above-described point are the same as those in the first example.

[Method of manufacturing protein photoelectric transducer]

An example of a method of manufacturing the protein photoelectric transducer will be described below. First, the electrode 21 is immersed in a solution containing the protein 22 and the buffer solution to immobilize the protein 22 on the electrode 21. Thus, the protein-immobilized electrode is formed. Next, the protein photoelectric transducer illustrated in, for example, FIG. 19, 20, or 21 is manufactured with use of the protein-immobilized electrode and the counter electrode 23.

[Operation of protein photoelectric transducer]

When single-color light with a wavelength of approximately 409 nm or light having a wavelength component with the wavelength of approximately 409 nm enters the protein 22 of the protein photoelectric transducer, the protein 22 generates electrons by photoexcitation, and the electrons travel to the electrode 21 by electron transfer. Then, a photocurrent is extracted from the electrode 21 and the counter electrode 23 to the outside.

As described above, in the second embodiment, the protein 22 made of the tin-substituted horse-heart cytochrome c or the tin-substituted bovine-heart cytochrome c having high light irradiation stability is immobilized on the electrode 21. Therefore, a novel protein photoelectric transducer capable of being stably used for a long time without a deterioration in the protein 22 by light irradiation for a long time is achievable.

The protein photoelectric transducer is allowed to be used for, for example, a photosensor or an image pickup element, and if necessary, the protein photoelectric transducer is allowed to be used with a photocurrent amplifier circuit. The photosensor is allowed to be used for various applications including detection of optical signals, and is also applicable to, for example, artificial retinas.

This protein photoelectric transducer is allowed to be used in various apparatuses and devices using photoelectric conversion, more specifically, for example, an electronic device having a light-sensitive section. The electronic device of this kind is basically not limited, and may be either portable or stationary, and specific examples of the electronic device include digital cameras, camcorders (videotape recorders), and the like.

(3. Third Embodiment)

[Liquid-uncontacting all-solid-state protein photoelectric transducer]

FIG. 22 illustrates a liquid-uncontacting all-solid-state protein photoelectric transducer according to a third embodiment. In the liquid-uncontacting all-solid-state protein photoelectric transducer, a solid protein layer is used. Herein, the solid protein layer means a layered solid formed by assembling proteins without including a liquid such as water. Moreover, "liquid-uncontacting" in the liquid-uncontacting all-solid-state protein photoelectric transducer means that the protein photoelectric transducer is used without allowing the interior and exterior thereof to contact a liquid such as water. Further, "all-solid-state" in the liquid-uncontacting all-solid-state protein photoelectric transducer means that all components of the transducer do not include a liquid such as water.

As illustrated in FIG. 22, the liquid-uncontacting all-solid-state protein photoelectric transducer has a configuration in which a solid protein layer 43 made of a protein is sandwiched between an electrode 41 and an electrode 42. The solid protein layer 43 is immobilized on the electrodes 41 and 42. Typically, the solid protein layer 43 is directly immobilized on the electrodes 41 and 42; however, if necessary, an intermediate layer not including a liquid such as water may be disposed between the solid protein layer 43 and the electrodes 41 and 42. The solid protein layer 43 does not include a liquid such as water. The solid protein layer 43 is configured of a monomolecular film or a multimolecular film of the protein.

FIG. 23 illsutrates an example of the configuration in which the solid protein layer 43 is configured of the multimolecular film. As illustrated in FIG. 23, the solid protein layer 43 is formed by laminating a number n (n is an integer of 2 or more) of monomolecular films which are formed by two-dimensionally assembling proteins 43a made of the tin-substituted horse-heart cytochrome c or the tin-substituted bovine-heart cytochrome c. FIG. 23 illustrates the case of n=3.

As materials of the electrodes 41 and 42, the same material as that of the electrode 21 is allowed to be used. To allow the entire or almost entire solid protein layer 43 sandwiched between the electrodes 41 and 42 to be irradiated with light, at least one of the electrodes 41 and 42 is preferably transparent to light used for photoexcitation of the solid protein layer 43. More specifically, the electrodes 41 and 42 are made of a conductive material transparent to light used for photoexcitation, for example, ITO, FTO, or Nesa glass, or is configured of an extremely thin metal film allowing light to pass therethrough.

Next, a method of manufacturing the liquid-uncontacting all-solid-state protein photoelectric transducer will be described below.

First, a solution including the protein 43a, typically a protein solution formed by dissolving a protein 43a in a buffer solution including water is adhered to one of the electrodes 41 and 42, for example, the electrode 41 by a dripping method, a spin coating method, a dipping method, a spray method, or the like.

Next, the electrode 41 to which the protein solution is adhered is kept at room temperature or a temperature lower than the room temperature to immobilize the protein 43a in the adhered protein solution on the electrode 41.

Next, the electrode 41 where the protein 43a in the protein solution is immobilized in such a manner is heated at a temperature lower than the denaturation temperature of the protein 43a to be dried, thereby evaporating and removing all liquids included in the protein solution.

Thus, only the protein 43a is immobilized on the electrode 41 to form the solid protein layer 43. The thickness of the solid protein layer 43 is easily controllable by the amount of the protein solution adhered to the electrode 41, the concentration of the protein solution, or the like.

Next, the electrode 42 is formed on the solid protein layer 43. The electrode 42 is allowed to be formed by depositing a conductive material by a sputtering method, a vacuum deposition method, or the like.

Thus, a target liquid-uncontacting all-solid-state protein photoelectric transducer is manufactured.

Next, an operation of the liquid-uncontacting all-solid-state protein photoelectric transducer will be described below.

A voltage (a bias voltage) is applied between the electrode 41 and the electrode 42 of the liquid-uncontacting all-solid-state protein photoelectric transducer to allow the electrode 42 to have a low potential. In this case, the electrode 41 is a transparent electrode. In the case where light does not enter the solid protein layer 43 of the liquid-uncontacting all-solid-state protein photoelectric transducer, the solid protein layer 43 have insulation properties, and a current does not flow between the electrode 41 and the electrode 42. This state is an OFF state of the liquid-uncontacting all-solid-state protein photoelectric transducer. On the other hand, as illustrated in FIG. 24, when light (hv) passes through the electrode 41 to enter the solid protein layer 43, the protein 43a forming the solid protein layer 43 is photoexcited, and as a result, the solid protein layer 43 becomes conductive. Then, electrons (e) pass from the electrode 42 to the electrode 41 though the solid protein layer 43 to allow a photocurrent to flow between the electrode 41 and the electrode 42. This state is an ON state of the liquid-uncontacting all-solid-state protein photoelectric transducer. Thus, the solid protein layer 43 serves as a photoconductor, and ON/OFF operation is allowed to be performed by the status of entry of light to the liquid-uncontacting all-solid-state protein photoelectric transducer.

It is considered that the solid protein layer 43 serves as a photoconductor as described above, because of an intramolecular electron transfer mechanism described in NPTL 4 and PTL 2. More specifically, when the electron transfer protein 43a forming the solid protein layer 43 is photoexcited, electron transition occurs between molecular orbitals, and as a result, electrons or holes are transferred from a part of the electron transfer protein 43a to another part thereof. Then, the transfer of the electrons or holes occurs continuously in a large number of electron transfer proteins 13a forming the solid protein layer 13, any as a result, a photocurrent flows between the electrode 41 and the electrode 42.

(Examples)

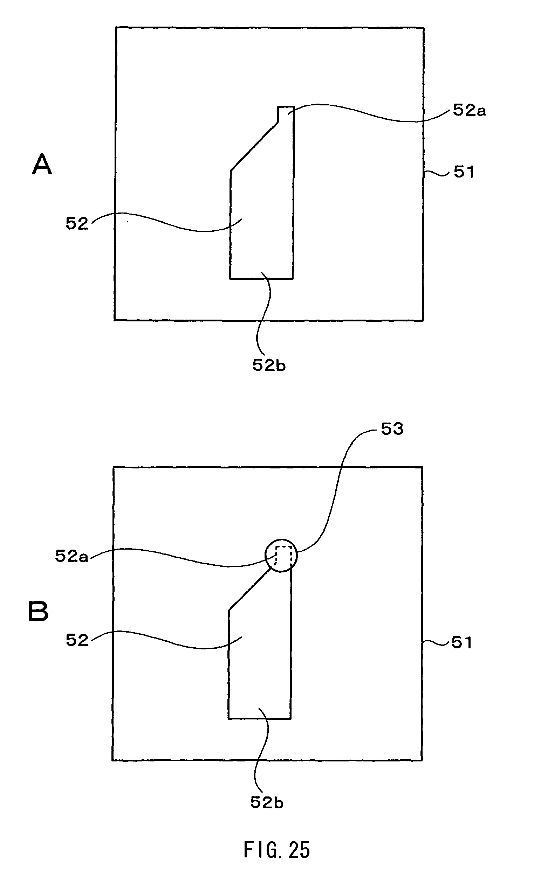

As illustrated in FIG. 25A, an ITO electrode 52 with a predetermined shape was formed as the electrode 41 on a glass substrate 51. The ITO electrode 52 had a thickness of 100 nm, and an area of 1 mm$^2$. The ITO electrode 52 served as a working electrode.

Protein solutions (200 $\mu$M) formed by dissolving the tin-substituted horse-heart cytochrome c, the tin-substituted bovine-heart cytochrome c, and the zinc-substituted horse-heart cytochrome c for comparison in high concentrations in a Tris-HCl buffer solution (pH 8.0) were prepared.

Next, as illustrated in FIG. 25B, 10 $\mu$L of each of the protein solutions prepared in the above-described manner was dropped on an end 52a of the ITO electrode 52 to adhere a protein droplet 53 to the ITO electrode 52.

Next, the ITO electrode 52 was left at room temperature for 2 hours or at 4°C for one day to immobilize the tin-substituted horse-heart cytochrome c, the tin-substituted bovine-heart cytochrome c, or the zinc-substituted horse-heart cytochrome c in the protein droplet 53 on the ITO electrode 52.

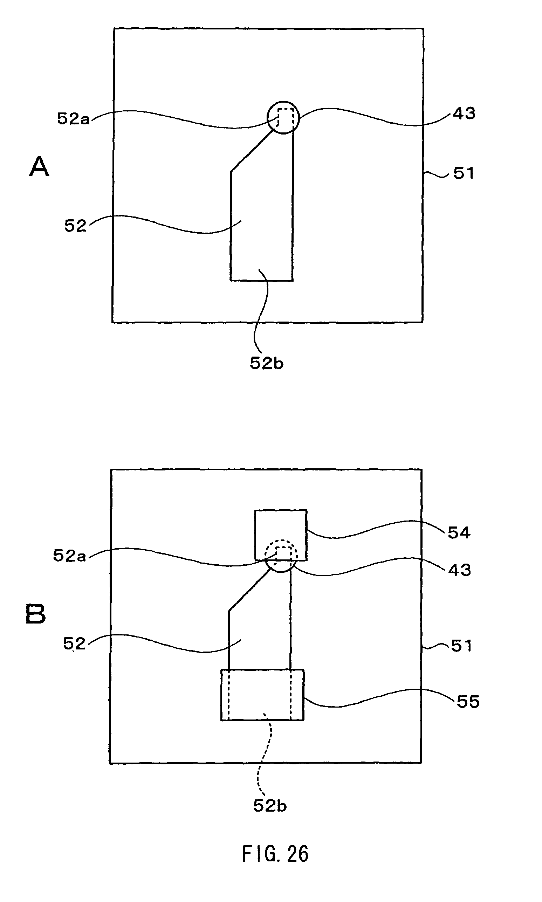

Next, this sample was placed in a dryer kept at a temperature of 30°C to 40°C to be dried for 30 minutes to 60 minutes. A liquid such as water contained in the protein droplet 53 was evaporated and removed by drying. As a result, only the tin-substituted horse-heart cytochrome c, the tin-substituted bovine-heart cytochrome c, or the zinc-substituted horse-heart cytochrome c remained on the ITO electrode 52, and as illustrated in FIG. 26A, the solid protein layer 43 was formed. The solid protein layer 43 had a thickness of approximately 1 $\mu$m.

Next, as illustrated in FIG. 26B, an electrode 54 was formed to overlap the solid protein layer 43, and an electrode 55 was formed to overlap the other end 52b of the ITO electrode 52. The electrode 55 was used as a counter electrode and a working electrode. These electrodes 54 and 55 each were configured of an Au film or an Al film, and the Au film had a thickness of 20 nm, and the Al film had a thickness of 50 nm. These electrodes 54 and 55 may be formed by masking a part other than regions where the electrodes 54 and 55 are formed, and depositing an electrode material by a sputtering method or a vacuum deposition method. These electrodes 54 and 55 had a rectangular or square planar shape.

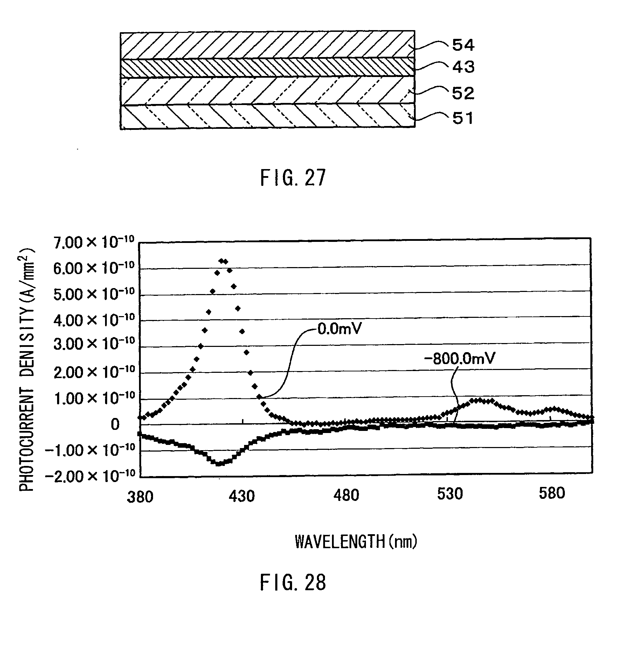

Thus, the liquid-uncontacting all-solid-state protein photoelectric transducer was manufactured. A sectional configuration of the liquid-uncontacting all-solid-state protein photoelectric transducer is illustrated in FIG. 27.

A large number of the liquid-uncontacting all-solid-state protein photoelectric transducers were manufactured in such a manner, and when resistance between the electrodes 54 and 55 was measured in the atmosphere, the resistance was distributed in a wide range of 1 k$\Omega$ to 30 M$\Omega$. The resistance between the electrodes 54 and 55 was distributed in such a wide range, because the thickness of the solid protein layer 43 varied from one transducer to another, or the protein 43a forming the solid protein layer 43 included a different kind of protein.

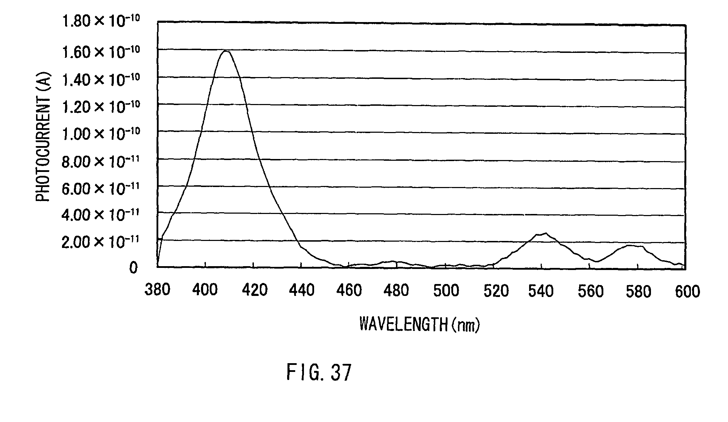

The photocurrent action spectra of the liquid-uncontacting all-solid-state protein photoelectric transducers were measured. As the protein 43a forming the solid protein layer 43, the tin-substituted bovine-heart cytochrome c and the zinc-substituted horse-heart cytochrome c were used. The measurement was performed under conditions that a working electrode of a potentiostat was connected to the electrode 54 connected to the ITO electrode 52, and a counter electrode and a reference electrode were connected to the electrode 55. The electrodes 54 and 55 each were configured of an Au film with a thickness of 20 nm. Measurement results of action spectra under potentials of 0 mV and -800 mV in the case where the zinc-substituted horse-heart cytochrome c was used as the protein 43a forming the solid protein layer 43 are illustrated in FIG. 28. Moreover, a measurement result of an action spectrum under a potential of 0 mV in the case where the tin-substituted bovine-heart cytochrome c was used as the protein 43a forming the solid protein layer 43 is illustrated in FIG. 37. As illustrated in FIGs. 28 and 37, even in both of the case where the zinc-substituted horse-heart cytochrome c was used as the protein 43a forming the solid protein layer 43, and the case where the tin-substituted bovine-heart cytochrome c was used as the protein 43a forming the solid protein layer 43, an action spectrum was allowed to be observed. In particular, as illustrated in FIG. 28, in the case where the zinc-substituted horse-heart cytochrome c was used as the protein 43a forming the solid protein layer 43, action spectra in both of positive and negative directions were allowed to be observed. Moreover, as illustrated in FIG. 28, the active spectrum was allowed to be measured at an overvoltage of -800 mV, and this is a new finding and an extremely noteworthy result.

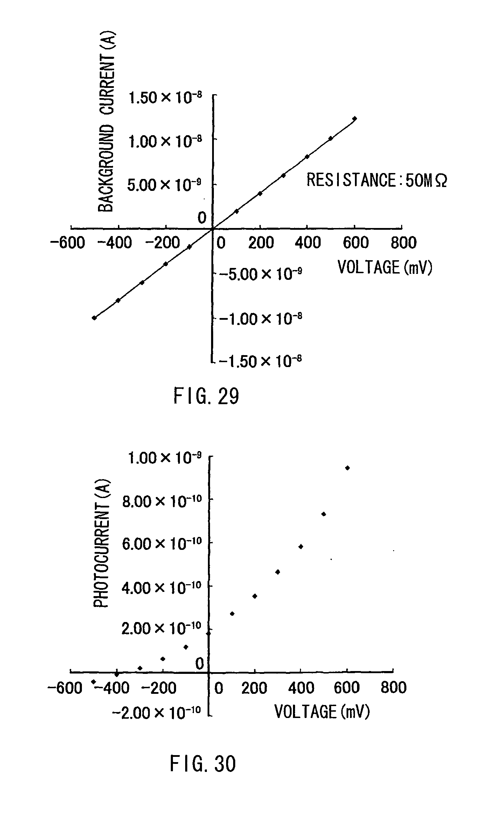

FIG. 29 illustrates measurement results of a background current (a current flowing when light is off) at respective voltages when a voltage (a bias voltage) was applied between the electrodes 54 and 55 of the liquid-uncontacting all-solid-state protein photoelectric transducer using the zinc-substituted horse-heart cytochrome c as the protein 43a forming the solid protein layer 43. As illustrated in FIG. 29, a curve representing a relationship between the voltage and the background current is a straight line, and the straight line indicates that conductivity of the solid protein layer 43 is similar to that of a semiconductor. It is found out from the gradient of the straight line that resistance between the electrodes 54 and 55 was approximately 50 MΩ.

FIG. 30 illustrates measurement results of a photocurrent (a current flowing when light is on) at respective voltages when a voltage was applied between the electrodes 54 and 55 of the liquid-uncontacting all-solid-state protein photoelectric transducer using the zinc-substituted horse-heart cytochrome c as the protein 43a forming the solid protein layer 43. As illustrated in FIG. 30, a curve representing a relationship between the voltage and the photocurrent is a substantially straight line, and the substantially straight line indicates that the solid protein layer 43 functions as a photoconductor.

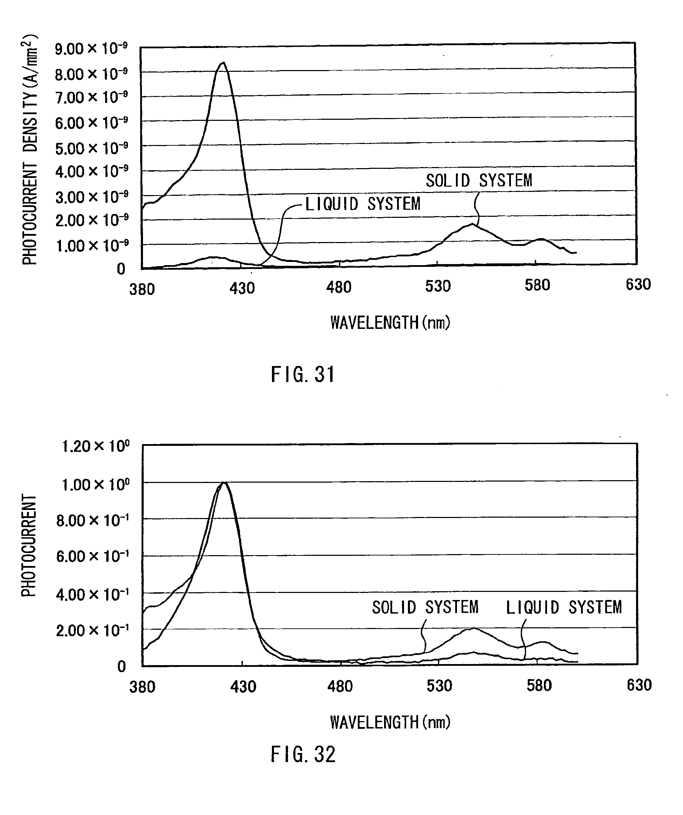

FIG. 31 illustrates measurement results of photocurrent action spectra of the liquid-uncontacting all-solid-state protein photoelectric transducer using the zinc-substituted horse-heart cytochrome c as the protein 43a forming the solid protein layer 43 and a liquid protein photoelectric transducer formed in a method which will be described later. In FIG. 31 and the following FIGs. 32 to 34, the above-described liquid-uncontacting all-solid-state protein photoelectric transducer is abbreviated to "solid system", and the liquid protein photoelectric transducer is abbreviated to "liquid system". The liquid protein photoelectric transducer was formed in the following steps. First, a predetermined part of a surface of an ITO film formed on a glass substrate was masked with a tape or a resin. Next, a part not masked of the ITO film was removed by wet etching for 90 seconds with use of 12 M HCl (50˚C). Next, the glass substrate was cleaned with water, and then the mask was removed, and the glass substrate was dried by flowing air. Next, the glass substrate was subjected to an ultrasonic process for 30 minutes in a 1% Alconox (a registered trademark) aqueous solution, and then, an ultrasonic process for 15 minutes in isopropanol, and the glass substrate was subjected to an ultrasonic process for 15 minutes in water twice. Next, after the glass substrate was immersed in 0.01 M NaOH for 3 minutes, the glass substrate was dried by flowing air or nitrogen. After that, the glass substrate was subjected to ultraviolet (UV)-ozone surface treatment for 15 minutes at approximately 60˚C. Thus, the ITO electrode was formed. The ITO electrode served as a working electrode. Next, in a first method, the ITO electrode formed in the above-described manner was rinsed with a protein solution (50 μM) formed by dissolving the zinc-substituted horse-heart cytochrome c in a Tris-HCl buffer solution (pH 8.0). Next, after the ITO electrode rinsed with the protein solution was kept at 4˚C for one night, the ITO electrode was rinsed with water, and dried by flowing air or nitrogen. In a second method, the ITO electrode formed in the above-described manner was rinsed with a protein solution (50 μM) formed by dissolving the zinc-substituted horse-heart cytochrome c in a Tris-HCl buffer solution (pH 8.0). Alternatively, the ITO electrode formed in the above-described manner was rinsed with a protein solution (5 μM) formed by dissolving the zinc-substituted horse-heart cytochrome c in a sodium phosphate buffer solution (pH 7.0). Next, the ITO electrode rinsed with the protein solution in such a manner was dried in a vacuum. After that, the ITO electrode was rinsed with water, and dried by flowing air or nitrogen. Thus, a protein-immobilized electrode formed by immobilizing a protein on the ITO electrode was formed. Next, a side where the protein was immobilized of the protein-immobilized electrode faced a clean ITO electrode separately formed as a facing electrode with a predetermined space in between, and peripheries of the protein-immobilized electrode and the ITO electrode were sealed with a resin. In the ITO electrode as the facing electrode, a pin hole communicated with the space between the protein-immobilized electrode and the ITO electrode was formed as an air inlet/outlet opening. Next, the protein-immobilized electrode and the ITO electrode of which the peripheries were sealed with the resin were immersed in an electrolytic solution contained in a container. As the electrolytic solution, an electrolytic solution formed by dissolving 0.25 mM of potassium ferrocyanide in a 10 mM sodium phosphate buffer solution (pH 7.0) was used. Next, the container was kept in a vacuum, and air in the space between the protein-immobilized electrode and the ITO electrode was discharged from the above-described pin hole to the outside. Next, the pressure of the container was returned to an atmospheric pressure to fill the space between the protein-immobilized electrode and the ITO electrode with the electrolytic solution. After that, the above-described pin hole was sealed with a resin. Thus, the liquid protein photoelectric transducer was formed.

FIG. 32 illustrates spectra of the liquid-uncontacting all-solid-state protein photoelectric transducer and the liquid protein photoelectric transducer illustrated in FIG. 31, where the spectra are normalized for a peak value of photocurrent density around a wavelength of 420 nm to be 1. As illustrated in FIG. 31, it was found out that even though there was a difference in photocurrent density between the spectra, peak wavelengths of the Soret band around a wavelength of 423 nm and the Q band around wavelengths of 550 nm and 583 nm in both of the spectra were the same as each other; therefore, a photocurrent derived from the zinc-substituted horse-heart cytochrome c was obtained in both of the liquid-uncontacting all-solid-state protein photoelectric transducer and the liquid protein photoelectric transducer. It was first found out by the inventors and the others of the present invention that in the liquid-uncontacting all-solid-state protein photoelectric transducer using the solid protein layer 43 made of the zinc-substituted horse-heart cytochrome c, a photocurrent derived from the zinc-substituted horse-heart cytochrome c was obtained in such a manner, and this is an unconventional and remarkable result.

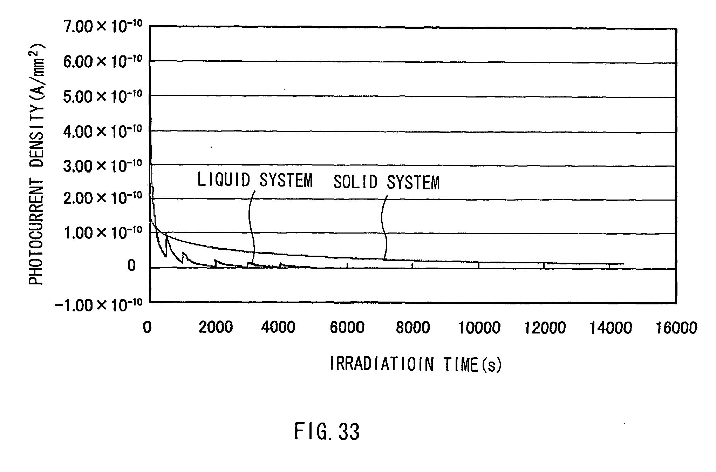

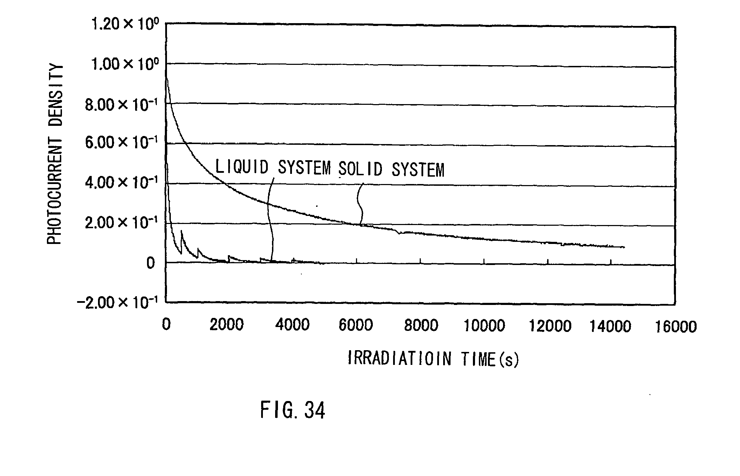

FIG. 33 illustrates a measurement result of photo-degradation curves (curves representing a reduction in photocurrent density with respect to light irradiation time) of the above-described liquid-uncontacting all-solid-state protein photoelectric transducer and the above-described liquid protein photoelectric transducer. In the measurement, photocurrent density was measured while the liquid-uncontacting all-solid-state protein photoelectric transducer and the liquid protein photoelectric transducer were irradiated with laser light with a wavelength of 405.5 nm at an intensity of 0.2 mW/mm$^2$. The laser light irradiation intensity was high, i.e., 0.2 mW/mm$^2$ to increase a photo-degradation rate and reduce a test time. FIG. 34 illustrates photo-degradation curves of the liquid-uncontacting all-solid-state protein photoelectric transducer and the liquid protein photoelectric transducer illustrated in FIG. 33, where the curves are normalized for the photocurrent density in the case where the irradiation time was 0 to be 1.

The photo-degradation curves illustrated in FIG. 34 was fitted by the following function.

$$f(x)=a\times\exp(b\times x)+c\times\exp(d\times x)$$

Coefficients a, b, c, and d of the function f(x) are as follows. A value following each coefficient in a bracket indicates a 95% confidence interval.

Liquid protein photoelectric transducer

$a=5.204\times10^{-9}(5.029\times10^{-9}, 5.378\times10^{-9})$
$b=-0.00412(-0.00441, -0.003831)$
$c=1.799\times10^{-10}(2.062\times10^{-11}, 3.392\times10^{-10})$
$d=-0.0004618(-0.0008978, -2.58\times10^{-5})$

Liquid-uncontacting all-solid-state protein photoelectric transducer

$a=5.067\times10^{-11}(4.883\times10^{-11}, 5.251\times10^{-11})$
$b=-0.0009805(-0.001036, -0.0009249)$
$c=4.785\times10^{-11}(4.58\times10^{-11}, 4.99\times10^{-11})$
$d=-0.0001298(-0.0001374, -0.0001222)$

Herein, a lifetime t of each of the liquid-uncontacting all-solid-state protein photoelectric transducer and the liquid protein photoelectric transducer is defined as:

$$t=[a/(a+c)](-1/b)+[c/(a+c)](-1/d)$$

In this definition, whereas the lifetime of the liquid protein photoelectric transducer is 306 seconds, the lifetime of the liquid-uncontacting all-solid-state protein photoelectric transducer is 4266 seconds. Therefore, it is apparent that the lifetime of the liquid-uncontacting all-solid-state protein photoelectric transducer is 14 times or over as long as that of the liquid protein photoelectric transducer.

It is to be noted that the photo-degradation curve of the liquid protein photoelectric transducer illustrated in FIG. 33 had a sawtooth waveform, because it was necessary to suspend the measurement to remove oxygen generated in the electrolytic solution, and a photocurrent slightly rose after an operation of removing oxygen.

Next, measurement results of frequency responses of the liquid-uncontacting all-solid-state protein photoelectric transducer and the liquid protein photoelectric transducer will be described below.

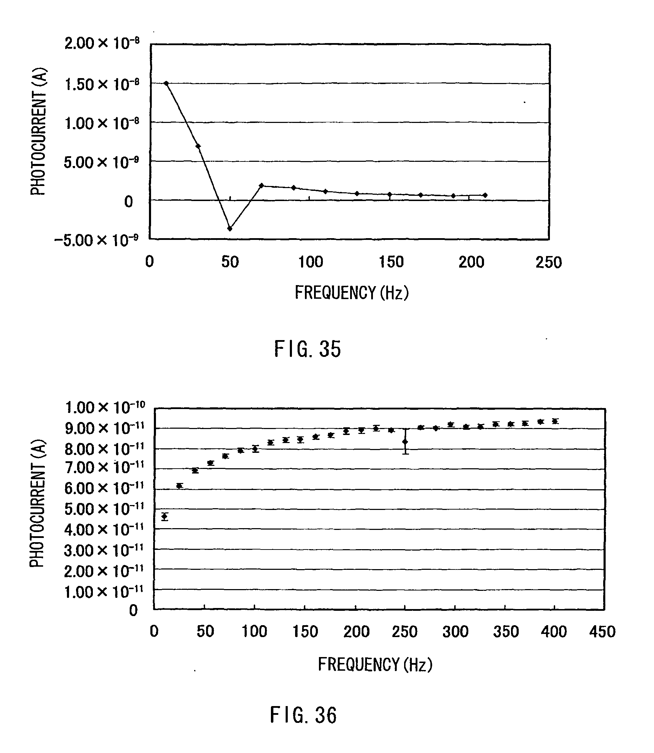

FIG. 35 illustrates measurement results of the frequency response of the liquid protein photoelectric transducer, and FIG. 36 illustrates measurement results of the frequency response of the liquid-uncontacting all-solid-state protein photoelectric transducer. In FIGs. 35 and 36, while the 3-dB bandwidth (a frequency at which a photocurrent value is 50% of a maximum photocurrent value) of the liquid protein photoelectric transducer was lower than 30 Hz, the 3-dB bandwidth of the liquid-uncontacting all-solid-state protein photoelectric transducer was 400 Hz or over. Accordingly, it is apparent that the response rate of the liquid-uncontacting all-solid-state protein photoelectric transducer is 13 times or over as high as that of the liquid protein photoelectric transducer.

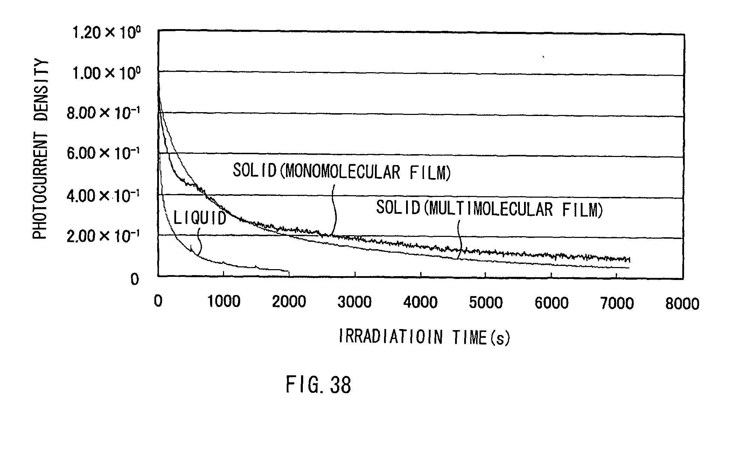

FIG. 38 illustrates measurement results of photo-degradation curves of the liquid-uncontacting all-solid-state protein photoelectric transducer using the tin-substituted bovine-heart cytochrome c as the protein 43a forming the solid protein layer 43 and the liquid protein photoelectric transducer using the tin-substituted bovine-heart cytochrome c, where the curves are normalized for the photocurrent density in the case where the irradiation time is 0 to be 1. A method of forming the liquid protein photoelectric transducer was the same as the above-described method, except that the tin-substituted bovine-heart cytochrome c was used instead of the zinc-substituted horse-heart cytochrome c. As the liquid-uncontacting all-solid-state protein photoelectric transducer, a transducer including a monomolecular film of the tin-substituted bovine-heart cytochrome c and a transducer including a multimolecular film of the tin-substituted bovine-heart cytochrome c were formed. In the measurement, photocurrent density was measured while the liquid-uncontacting all-solid-state protein photoelectric transducers and the liquid protein photoelectric transducer were irradiated with laser light with a wavelength of 405.5 nm at an intensity of 0.2 mW/mm$^2$. The laser light irradiation intensity was high, i.e., 0.2 nW/mm$^2$ to increase the photo-degradation rate and reduce the test time.

The photo-degradation curves illustrated in FIG. 38 were fitted by the following function.

$$f(x)=a\times exp(b\times x)+c\times exp(d\times x)$$

Coefficients a, b, c, and d of the function f(x) are as follows.
Liquid protein photoelectric transducer

a=1.72$\times$10$^{-8}$
b=-0.00462
c=3.51$\times$10$^{-9}$
d=-0.000668

Liquid-uncontacting all-solid-state protein photoelectric transducer (monomolecular film)

a=0.4515
b=-0.002599
c=0.3444
d=-0.0001963

Liquid-uncontacting all-solid-state protein photoelectric transducer (multimolecular film)

a=0.5992
b=-0.002991
c=0.2371
d=-0.0001513

Herein, average time constants of photo-degradation of the liquid-uncontacting all-solid-state protein photoelectric transducers and the liquid protein photoelectric transducer are as follows.
Liquid protein photoelectric transducer: 2.54$\times$10$^2$ seconds
Liquid-uncontacting all-solid-state protein photoelectric transducer (monomolecular film): 2.71$\times$10$^3$ seconds
Liquid-uncontacting all-solid-state protein photoelectric transducer (multimolecular film): 2.73$\times$10$^3$ seconds

In the same manner as described above, the lifetime t of each of the liquid-uncontacting all-solid-state protein photoelectric transducers and the liquid protein photoelectric transducer is defined as:

$$t=[a/(a+c)](-1/b)+[c/(a+c)](-1/d)$$

In this definition, whereas the lifetime of the liquid protein photoelectric transducer is 434 seconds, the lifetimes of the liquid-uncontacting all-solid-state protein photoelectric transducer (monomolecular film) and the liquid-uncontacting all-solid-state protein photoelectric transducer (multimolecular film) were 2423 seconds and 2113 second, respectively. Therefore, it was apparent that the lifetimes of the liquid-uncontacting all-solid-state protein photoelectric transducers are approximately 5 times or over as long as that of the liquid protein photoelectric transducer.

In the liquid-uncontacting all-solid-state protein photoelectric transducer according to the third embodiment, the following various advantages are allowed to be obtained. Specifically, the interior of the liquid-uncontacting all-solid-state protein photoelectric transducer does not contain water, and the liquid-uncontacting all-solid-state protein photoelectric transducer is operable without contacting water; therefore, the liquid-uncontacting all-solid-state protein photoelectric transducer is allowed to be mounted in an electronic device as an alternative to a photoelectric transducer using a semiconductor in related art. Moreover, since the interior of the liquid-uncontacting all-solid-state protein photoelectric transducer does not contain water, thermal denaturation, radical damage, decay, or the like of the protein due to the presence of water is preventable, and stability is high, and durability is superior. Moreover, since no water is present inside and outside of the liquid-uncontacting all-solid-state protein photoelectric transducer, there is no risk of an electrical shock, and strength is easily secured.

Further, in the liquid-uncontacting all-solid-state protein photoelectric transducer, the solid protein layer 43 is directly immobilized on the electrodes 41 and 42 without a linker molecule or the like in between; therefore, compared to the case where the solid protein layer 43 is immobilized on the electrodes 41 and 42 with the linker molecule or the like in between, a high photocurrent is allowed to be obtained. Moreover, in addition to directly immobilizing the solid protein layer 43 on the electrodes 41 and 42, the solid protein layer 43 is allowed to be formed with an extremely thin thickness; therefore, a distance between the electrode 41 and the electrode 22 are allowed to be extremely small. Therefore, the liquid-uncontacting all-solid-state protein photoelectric transducer is allowed to be configured to have a thin thickness, and the electrodes 41 and 42 are made transparent; therefore, a laminate of a large number of liquid-uncontacting all-solid-state protein photoelectric transducers is allowed to be used. Further, in the liquid-uncontacting all-solid-state protein photoelectric transducer, the size of the protein 43a forming the solid protein layer 43 is extremely small, approximately 2 nm; therefore, for example, a position where light enters in the solid protein layer 43 is allowed to be detected extremely precisely. Thus, a high-definition photosensor or image pickup element is achievable.

Moreover, the photoconductive effect of the protein 43a is presumed to be due to "one-photon multielectron generation". However, in the liquid protein photoelectric transducer, the resistance (solution resistance) of a solution included between electrodes is high; therefore, it is considered that the "one-photon multielectron generation" is hindered. On the other hand, in the liquid-uncontacting all-solid-state protein photoelectric transducer, the solution resistance does not exist; therefore, the "one-photon multielectron generation" is possible, and a significant improvement in photoelectric conversion efficiency is achievable, and a higher photocurrent is allowed to be obtained.

An optical switching element, a photosensor, an image pickup element, and the like are achievable with use of the liquid-uncontacting all-solid-state protein photoelectric transducer. As described above, since the liquid-uncontacting all-solid-state protein photoelectric transducer has high frequency response, an optical switching element capable of high-speed switching, a photosensor with high-speed response, an image pickup element capable of picking up an image of an object moving at high speed, and the like are achievable. Then, when the liquid-uncontacting all-solid-state protein photoelectric transducer is used in the optical switching element, the photosensor, the image pickup element, and the like, a superior electronic device is achievable.

(4. Fourth Embodiment)

[Metal-substituted cytochrome c]

In a fourth embodiment, a metal-substituted horse-heart cytochrome c and a metal-substituted bovine-heart cytochrome c formed by substituting a metal other than tin and zinc for iron as central metals of hemes of a horse-heart cytochrome c and bovine-heart cytochrome c will be described below.
Table 4 illustrates examples of the metal used in the metal-substituted horse-heart cytochrome c and the metal-substituted bovine-heart cytochrome c. It is known that a porphyrin including the metal as a central metal fluoresces (refer to NPTL 5). In Table 4, a value provided below each chemical symbol indicates a phosphorescence lifetime measured with use of metal octaethylporphyrin.
[Table 4]

|  | Be(II) 12 ms |  |  |  |  |  |  |  |
|---|---|---|---|---|---|---|---|---|
| Na(I) up to 50 ms | Mg(II) 130 ms |  |  |  |  |  |  |  |
| K(I) up to 50 ms | Ca(II) 63 ms | Sc(III) 400 ms | Ti(IV) 41 ms |  |  | AI(III) 115 ms | Si(IV) 95 ms |  |
|  | Sr(II) 7 ms | Y(III) 55 ms | Zr(IV) 65 ms | Nb(V) 14.5 ms | Zn(II) 75 ms |  | Ge (IV) 42 ms | As(V) 86 ms |
|  | Ba(II) 8 ms | Lu(III) 7.8 ms | Hf(IV) 8.4 ms | Ta(V) 2.5 ms | Cd(II) 7 ms |  | Sn(IV) 30 ms | Sb(V) 26 ms |
|  |  |  | Th(IV) 0.43 ms |  |  |  | Pd(IV) 2.8 ms |  |

In Table 4, the phosphorescence lifetime of tin (Sn) is 30 ms, and it is considered that metals with a phosophorescence lifetime equal to or shorter than that of tin (Sn) do not damage a protein or a porphyrin by light irradiation. In Table 4, such metals include beryllium (Be), strontium (Sr), niobium (Nb), barium (Ba), lutetium (Lu), hafnium (Hf), tantalum (Ta), cadmium (Cd), antimony (Sb), thorium (Th), lead (Pb), and the like.

Therefore, any of these metals is substituted for iron as the central metals of the hemes of the horse-heart cytochrome c and the bovine-heart cytochrome c. The same method as the method described in the first embodiment is allowed to be used for substitution.
The metal-substituted horse-heart cytochrome c and the metal-substituted bovine-heart cytochrome c obtained in such a manner are as stable with respect to light irradiation as the tin-substituted horse-heart cytochrome c and the tin-substituted bovine-heart cytochrome c, and photolysis hardly occurs.

The range of a fluorescence excitation lifetime necessary for the metal-substituted horse-heart cytochrome c and the metal-substituted bovine-heart cytochrome c will be described below.
The intramolecular hole transfer rate of the zinc-substituted horse-heart cytochrome c (refer to NPTL 4) is as follows. In the case where molecular orbital numbers based on NPTL 4 is used as numbers of molecular orbitals (MO), in transfer between MO3272 and MO3271, the intramolecular hole transfer rate is $1.5 \times 10^{11}$ s$^{-1}$, and in transfer between MO3268 and MO3270, the intramolecular hole transfer rate is $2.0 \times 10^{10}$ s$^{-1}$. Therefore, the lower limit of the intramolecular hole transfer rate is set to the latter case, i.e., $2.0 \times 10^{10}$ s$^{-1}$.

The fluorescence excitation lifetime of the tin-substituted horse-heart cytochrome c (refer to NPTL 3) is $8.0 \times 10^{-10}$ s. The fluorescence excitation lifetime of the zinc-substituted horse-heart cytochrome c is $3.2 \times 10^{-10}$ s.
The number of intramolecular hole transfers in one electron excitation of the tin-substituted horse-heart cytochrome c is $(1.5 \times 10^{11}$ s$^{-1}) \times (8.0 \times 10^{-10}$ s$)=120$ in transfer between MO3272 and MO3271, and $(2.0 \times 10^{10}$ s$^{-1}) \times (8.0 \times 10^{-10}$ s$)=16$ in transfer between MO3268 and MO3270. Therefore, the lower limit of the number of intramolecular hole transfers in one electron excitation is set to the latter case, i.e., 16.
In this case, the fluorescence excitation lifetime necessary to cause at least one hole transfer is $8.0 \times 10^{-10}$ s/16$=5.0 \times 10^{-11}$ s.

Accordingly, the range of the fluorescence excitation lifetime ($\tau$) of the metal-substituted horse-heart cytochrome c and the metal-substituted bovine-heart cytochrome c necessary to cause hole transfer without causing damage on a protein part or porphyrin by light irradiation is $5.0 \times 10^{-11}$ s (fluorescence excitation lifetime necessary to cause at least one hole transfer)$<\tau \leq 8.0 \times 10^{-10}$ s (fluorescence excitation lifetime of the tin-substituted horse-heart cytochrome c).
In the metal-substituted horse-heart cytochrome c and the metal-substituted bovine-heart cytochrome c according to the fourth embodiment, the same advantages as those in the tin-substituted horse-heart cytochrome c and the tin-substituted bovine-heart cytochrome c according to the first embodiment are allowed to be obtained.

(5. Fifth Embodiment)

[Protein photoelectric transducer]

In a fifth embodiment, as the protein 22 in the second embodiment, the metal-substituted horse-heart cytochrome c or the metal-substituted bovine-heart cytochrome c according to the fourth embodiment is used. Points other than the above-described point are the same as those in the second embodiment.
According to the fifth embodiment, the same advantages as those in the second embodiment are allowed to be obtained.
Although the embodiments of the present invention are described in detail, the invention is not limited thereto, and may be variously modified based on the technical ideas of the invention.
For example, the values, structures, configurations, shapes, materials, and the like used in the above-described embodiments are merely illustrative, and different values, structures, configurations, shapes, materials, and the like may be used as necessary.

**Claims**

1.  A protein photoelectric transducer comprising:

    a tin-substituted cytochrome c formed by substituting tin for iron as a central metal of a heme of a mammalian cytochrome c, or a protein having an amino-acid sequence formed by deletion, substitution, or addition of one or more amino acids in the amino-acid sequence of a mammalian cytochrome c, and including tin.

2.  The protein photoelectric transducer according to claim 1, wherein the mammalian cytochrome c is a horse-heart cytochrome c.

3.  The protein photoelectric transducer according to claim 1, wherein the mammalian cytochrome c is a bovine-heart cytochrome c.

4.  A tin-substituted cytochrome c formed by substituting tin for iron as a central metal of a heme of a mammalian cytochrome c.

5.  The tin-substituted cytochrome c according to claim 4, wherein the mammalian cytochrome c is a horse-heart cytochrome c.

6.  The tin-substituted cytochrome c according to claim 4, wherein the mammalian cytochrome c is a bovine-heart cytochrome c.

7.  A protein photoelectric transducer comprising:

    a metal-substituted cytochrome c which is formed by substituting a metal other than zinc and tin for iron as a central metal of a heme of a mammalian cytochrome c, and has a fluorescence excitation lifetime $\tau$ of $5.0 \times 10^{-11}$ s $< \tau \leq 8.0 \times 10^{-10}$ s, or a protein which has an amino-acid sequence formed by deletion, substitution, or addition of one or more amino acids in the amino-acid sequence of a mammalian cytochrome c, includes a metal other than zinc and tin, and has a fluorescence excitation lifetime $\tau$ of $5.0 \times 10^{-11}$ s $< \tau \leq 8.0 \times 10^{-10}$ s.

8.  The protein photoelectric transducer according to claim 7, wherein the mammalian cytochrome c is a horse-heart cytochrome c.

9.  The protein photoelectric transducer according to claim 7, wherein the mammalian cytochrome c is a bovine-heart cytochrome c.

10. The protein photoelectric transducer according to claim 7, wherein the metal other than zinc and tin is beryllium, strontium, niobium, barium, lutetium, hafnium, tantalum, cadmium, antimony, thorium, or lead.

FIG. 1

FIG. 2

FIG. 3

FIG. 4

FIG. 5

FIG. 6

FIG. 7

FIG. 8

FIG. 9

EP 2 472 627 A1

FIG. 10

EP 2 472 627 A1

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

A

52a

51

52

52b

53

52a

B

52

51

52b

FIG. 25

FIG. 26

F I G. 27

WAVELENGTH (nm)

F I G. 28

FIG. 29

FIG. 30

FIG. 31

FIG. 32

FIG. 33

FIG. 34

FIG. 35

FIG. 36

FIG. 37

FIG. 38

EP 2 472 627 A1

FIG. 39

FIG. 40

FIG. 41

**INTERNATIONAL SEARCH REPORT**

| International application No. |
| --- |
| PCT/JP2010/063472 |

A. CLASSIFICATION OF SUBJECT MATTER
*H01L51/42*(2006.01)i, *H01L27/146*(2006.01)i, *H01M14/00*(2006.01)i

According to International Patent Classification (IPC) or to both national classification and IPC

B. FIELDS SEARCHED

Minimum documentation searched (classification system followed by classification symbols)
H01L51/42, H01L27/146, H01M14/00

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | Jane M. Vanderkooi et al., "Metallocytochromes c : Characterization of Electronic Absorption and Emission Spectra of Sn4+ and Zn2+ Cytochromes c", Eur. J. Biochem., 1976, Vol.64, No.2, pp.381-387 | 4-6<br>1-3 |
| Y | JP 2007-220445 A (Sony Corp.),<br>30 August 2007 (30.08.2007),<br>claim 1<br>& US 2008/0000525 A1 & EP 1821324 A2 | 1-3 |
| A | George McLendon et al., "Equilibrium and Kinetic Studies of Unfolding of Homologous Cytochromes c", J. Biol. Chem., 1978, Vol.253, No.11, pp.4004-4008 | 2-3,5-6,8-9 |

☒ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>06 September, 2010 (06.09.10) | Date of mailing of the international search report<br>14 September, 2010 (14.09.10) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/063472 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2-281770 A  (Director General, Agency of Industrial Science and Technology), 19 November 1990 (19.11.1990), fig. 1 (Family: none) | 1-10 |

Form PCT/ISA/210 (continuation of second sheet) (July 2009)

## REFERENCES CITED IN THE DESCRIPTION

**Patent documents cited in the description**

- JP 2007220445 A
- JP 2009021501 A

**Non-patent literature cited in the description**

- **McLendon, G. ; Smith, M.** *J.Biol.Chem.,* 1978, vol. 253, 4004
- **Moza, B.** *Biochim. Biophys. Acta,* 2003, vol. 1646, 49
- **Vanderkooi, J. M.** *Eur. J. Biochem.,* 1976, vol. 64, 381-387
- **Tokita, Y.** *J. Am. Chem. Soc.,* 2008, vol. 130, 5302
- Optical spectra and electronic structure of porphyrins and related rings. **Gouterman M.** The Porphyrins. Academic Press, 1978, vol. 3, 1-156